# EUROPEAN PATENT APPLICATION

(11) **EP 2 006 884 A2**
(43) Date of publication of application: **24.12.2008**
(21) Application number: 07715038.1
(22) Date of filing: 28.02.2007
(51) Int. Cl.: H01L 21/027, H01L 21/68

(54) **MOBILE DEVICE, EXPOSURE DEVICE, EXPOSURE METHOD, MICRO-MOTION BODY, AND DEVICE MANUFACTURING METHOD**

(30) Priority: 30.03.2006 JP 2006095982
(71) Applicant: Nikon Corporation, Tokyo 100-8331 (JP)
(72) Inventor: TANAKA, Keiichi, Chiyoda-ku, Tokyo 100-8331 (JP)
(74) Representative: Viering, Jentschura & Partner
(86) International application number: PCT/JP2007/053723
(87) International publication number: WO 2007/113955

(57) **Abstract**

Power-transmitting, waste-heat frames (24A, 24B) can continually absorbs heat radiated from wafer stages (WST1, WST2), and therefore it becomes possible to suppress adverse influence on exposure accuracy due to the heat generated at the wafer stages (WST1, WST2). In this case, unlike the conventional method, it is not necessary to connect a conduit (tube) for supplying coolant to the wafer stages (WST1, WST2) from the outside, and accordingly declines in movement accuracy of the wafer stages (WST1, WST2) due to tension of such a conduit can be prevented. Also from this standpoint, the exposure accuracy can be maintained at high accuracy.

## Description

The present invention relates to movable body apparatus, exposure apparatus and exposure methods, fine movement members, and device manufacturing methods, and more specifically, to a movable body apparatus that is equipped with a movable body that moves at least in one axial direction in a horizontal plane, an exposure apparatus that is equipped with the movable body apparatus and an exposure method that uses the movable body apparatus, a fine movement member that is supported finely drivable with respect to the movable body, and a device manufacturing method that uses the exposure apparatus or the exposure method.

In recent years, sequential-motion exposure apparatus such as the following have mainly been used in lithography processes for the manufacture of semiconductor devices, liquid crystal display elements, and the like, with increasingly greater integration of semiconductors and the like: reduction projection-exposure apparatus by a step-and-repeat method (so-called steppers), and scanning projection-exposure apparatus by a step-and-scan method (so-called scanning steppers (which are also called scanners). In these types of exposure apparatus, as a driving device that drives a photosensitive object (hereinafter, referred to as a "wafer") such as a wafer, a glass plate, or the like, a wafer stage apparatus is used that has a coarse movement stage, which is driven within a two-dimensional plane using a biaxial linear motor, a planar motor, or the like, and a fine movement stage that holds the wafer on the coarse movement stage and is driven finely in the Z-axis direction, in an inclined direction, or the like, by a voice coil motor or the like.

The driving device such as the linear motor, planar motor, voice coil motor, or the like in the wafer stage apparatus described above is equipped with an armature unit having a plurality of coils and a magnet unit having a plurality of magnets, and therefore, the coils constituting the armature unit produce heat due to electric current being supplied to the coils. Accordingly, in order to suppress adverse influences of this heat produced by the coils on exposure accuracy, recently, a conduit (tube) has been connected to part of the wafer stage, and coolant has been supplied through the conduit (tube) to the vicinity of the heat-producing portion. Since the conduit (tube) for coolant supply is pulled along with movement of the stage, however, the position controllability of the wafer is reduced, which consequently causes exposure accuracy to decline.

Also, to a conventional wafer stage, wiring and the like for use in the linear motor or planar motor, and voice coil motor is connected from the outside, and therefore, similar to the case of the conduit (tube) discussed above, this wiring and the like are pulled along with driving of the stage which causes position controllability of the wafer to decline.

The present invention has been made under the circumstances described above, and according to a first aspect of the present invention, there is provided a first movable body apparatus, comprising: a movable body having a heat-dissipating section; a driving device that two-dimensionally drives the movable body in a predetermined plane; and a waste-heat member that is disposed in a non-contacting manner relative to the movable body and absorbs heat radiated from the movable body; wherein one of the waste-heat member and the heat-dissipating section extends over a predetermined range in one axial direction in the predetermined plane, and the other of the waste-heat member and the heat-dissipating section extends over a predetermined range in a direction orthogonal to the one axial direction in the predetermined plane.

With this apparatus, because the waste-heat member absorbs heat radiated from the movable body, it becomes possible to suppress heat-wise influence of the movable body. In this case, one of the waste-heat member and the heat-dissipating section equipped in the movable body extends over a predetermined range in one axial direction, and also the other extends over a predetermined range in a direction orthogonal to the one axial direction, and therefore, even when the movable body moves in a range in a two-dimensional plane where at least part of the waste-heat member and at least part of the heat-dissipating section face in a non-contacting manner, the waste-heat member can absorb heat radiated from the movable body.

According to a second aspect of the present invention, there is provided a second movable body apparatus, comprising: a movable body; an electric-power-input section which is disposed on the movable body and to which electric power is wirelessly input; an electric-power-output section that is disposed in a non-contacting manner relative to the movable body in a state of continually opposed to at least part of the electric-power-input section, and wirelessly outputs electric power toward the electric-power-input section; and a driving device that drives the movable body by using electric power input to the electric-power-input section.

With this apparatus, the electric-power-input section to which electric power is wirelessly input is disposed on the movable body, and also the electric-power-output section that wirelessly outputs electric power toward the electric-power-input section is disposed in a non-contacting manner relative to the movable body in a state of continually facing at least part of the electric-power-input section. Therefore, wiring for supplying electric power to the driving device that drives the movable body does not have to be connected to the movable body. Thus, decrease in movement accuracy of the movable body due to tension of the wiring can be prevented.

According to a third aspect of the present invention, there is provided a third movable body apparatus, comprising: a movable body; a meter disposed on the movable body; a transmitter that is disposed on the movable body and wirelessly transmits a signal output from the meter; and a receiver that is disposed in a non-contacting manner relative to the movable body in a state of continually opposed to at least part of the transmitter, and receives a signal transmitted wirelessly from the transmitter.

With this apparatus, the transmitter that wirelessly transmits a signal output from the meter is disposed on the movable body, and the receiver that receives a signal from the transmitter is disposed in a non-contacting manner relative to the movable body in a state of continually facing at least part of the transmitter, and therefore, wiring for taking a signal output from the meter does not have to be connected to the movable body. Accordingly, decrease in movement accuracy of the movable body due to tension of the wiring can be prevented.

According to a fourth aspect of the present invention, there is provided a first exposure apparatus that forms a pattern on an object by exposing the object, the apparatus comprising: the first movable body apparatus of the present invention, in which the object is mounted on the movable body.

With this apparatus, since an object that is subject to exposure is mounted on the movable body of which decrease in movement accuracy is prevented, the object can be moved with high accuracy, and hence, it becomes possible to improve exposure accuracy.

According to a fifth aspect of the present invention, there is provided a second exposure apparatus that forms a pattern on an object by exposing the object, the apparatus comprising: the first movable body apparatus of the present invention comprising a plurality of movable bodies, wherein in exchange of one movable body of the plurality of movable bodies on which the object is mounted, another movable body, on which an object to be exposed next to the object on the one movable body is mounted, is placed at an exposure position where exposure of the object is performed in the predetermined plane.

With this apparatus, the first movable body apparatus of the present invention is provided that is equipped with a plurality of movable bodies with which high-precision alignment can be performed, and in exchange of one movable body of the plurality of movable bodies on which an object is mounted, another movable body, on which an object that should be exposed next to the object on the one movable body is mounted, can be placed at an exposure position where exposure of an object is performed in a predetermined plane, and therefore, exposure to a plurality of objects can consecutively be performed. Accordingly, it becomes possible to perform highly accurate exposure with high throughput.

According to a sixth aspect of the present invention, there is provided a first exposure method of forming a pattern on an object, the method comprising: driving the movable body of the first movable body apparatus of the present invention in a state where the object is mounted on the movable body, when exposure of the object is performed.

With this method, since an object that is subject to exposure is mounted on the movable body of which decrease in movement accuracy is prevented, the obj ect can be moved with high accuracy, and hence, it becomes possible to improve exposure accuracy.

According to a seventh aspect of the present invention, there is provided a second exposure method of forming a pattern on an obj ect, the method comprising: by using the first movable body apparatus of the present invention comprising a plurality of movable bodies, driving one movable body of the plurality of the movable bodies that is situated at an exposure position where exposure of the object is performed in the predetermined plane, and placing another movable body, on which an object to be exposed next to the object on the one movable body is mounted, at the exposure position in exchange of the one movable body.

With this method, the first movable body apparatus of the present invention is provided that is equipped with a plurality of movable bodies with which high-precision alignment can be performed, and in exchange of one movable body of the plurality of movable bodies on which an object is mounted, another movable body, on which an object that should be exposed next to the object on the one movable body is mounted, can be placed at an exposure position where exposure of an object is performed in a predetermined plane, and therefore, exposure to a plurality of objects can consecutively be performed. Accordingly, it becomes possible to perform highly accurate exposure with high throughput.

According to an eighth aspect of the present invention, there is provided a fourth movable body apparatus, comprising: a movable body; a fine movement member supported in a non-contacting manner relative to the movable body; and a driving mechanism having four armature coils that are disposed on the movable body and a magnet unit that is disposed on the fine movement member and cooperatively operates with the four armature coils to generate a driving force.

With this apparatus, the resultant of the respective driving forces generated by the four armature coils and the magnet unit corresponding to the four armature coils cooperatively operating can be made to act on the fine movement member, and therefore consumption current per armature coil can be suppressed. Thus, heat generation per armature coil can be suppressed.

According to a ninth aspect of the present invention, there is provided a fine movement member that is supported finely drivable relative to a movable body, the member comprising: a fine movement main body supported in a non-contacting manner relative to the movable body; and a magnet unit that is disposed on the fine movement main body, and operates cooperatively with four armature coils disposed on the movable body to generate a driving force.

With this fine movement member, the resultant of the respective driving forces generated by the four armature coils and the magnet unit corresponding to the four armature coils cooperatively operating can be made to act on the fine movement main body, and therefore consumption current per armature coil can be suppressed. Thus, heat generation per armature coil can be suppressed.

According to a tenth aspect of the present invention, there is provided a fifth movable body apparatus, comprising: a movable body; and the fine movement member of the present invention supported in a non-contacting manner relative to the movable body.

According to an eleventh aspect of the present invention, there is provided a third exposure apparatus that forms a pattern on an object, the apparatus comprising: the fourth movable body apparatus of the present invention, in which the object is mounted on the fine movement member.

With this apparatus, decrease in exposure accuracy caused by heat generation can be suppressed.

Further, by forming a pattern on a substrate using the first exposure method of the present invention, productivity of microdevices with high integration can be improved. Further, by forming a pattern on a substrate using the first exposure apparatus of the present invention, productivity of microdevices with high integration can be improved. According, it can also be said from another aspect that the present invention is a device manufacturing method including a pattern transfer process to a substrate using the first exposure method of the present invention, or a device manufacturing method including a pattern transfer process to a substrate using the first exposure apparatus of the present invention.
FIG. 1 is a schematic view showing an exposure apparatus according to an embodiment.
FIG. 2 is a plan view showing a wafer stage apparatus in FIG. 1.
FIG. 3A is a longitudinal sectional view of a wafer stage WST1, and FIG. 3B is a view showing a disassembled state of FIG. 3A.
FIG. 4 is a view used to explain the configuration and operation of a planar motor.
FIG. 5 is a pattern diagram showing a state of a base BS viewed from the +X direction.
FIG. 6A is a perspective view showing a movable element constituting a fine movement mechanism, and FIG. 6B is a perspective view showing a fixed element constituting the fine movement mechanism.
FIGS. 7A to 7C are views used to explain a driving method of a fine movement stage by the fine movement mechanism.
FIG. 8 is a longitudinal sectional view of an empty-weight-canceling mechanism.
FIG. 9 is a view used to explain the internal configuration of a power-receiving, heat-dissipating arm.
FIG. 10 is a view used to explain the internal configuration of a power-transmitting, waste-heat frame.
FIG. 11 is a view showing heads disposed on the wafer stage and scales disposed on the power-transmitting, waste-heat frame.
FIGS. 12A and 12B are views (No. 1) used to explain a parallel-processing operation in the exposure apparatus.
FIGS. 13A and 13B are views (No. 2) used to explain a parallel-processing operation in the exposure apparatus.

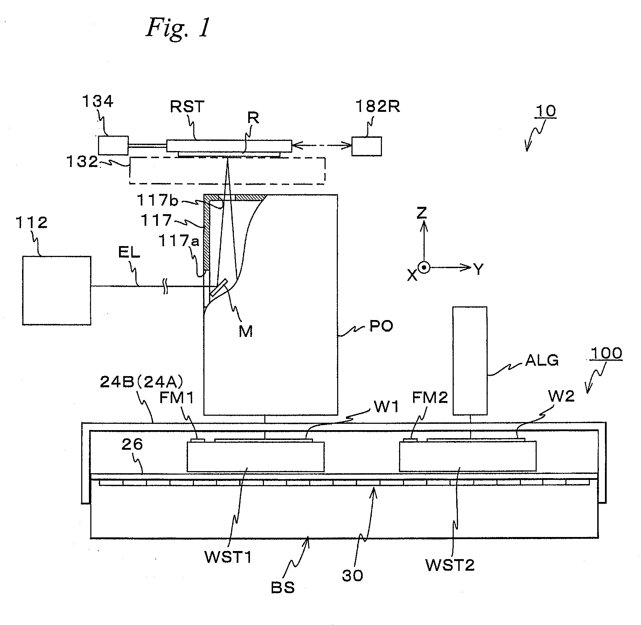

An embodiment of the present invention is described below with reference to FIGS. 1 to 13B.

FIG. 1 schematically shows the overall configuration of an exposure apparatus 10 related to an embodiment. In the depicted exposure apparatus 10, as discussed below, a projection optical system PO is used, and therefore, in the following description, a Z-axis direction is a direction of the optical axis of the projection optical system PO, a Y-axis direction is a horizontal direction in a plane orthogonal to the Z-direction, within the page surface of FIG. 1, and an X-axis direction is a direction orthogonal to the page surface.

The exposure apparatus 10 projects an image of part of a circuit pattern, defined on a reticle R, via the projection optical system PO onto a wafer W1 (or wafer W2), while relatively scanning the reticle R and wafer W1 (or wafer W2) in a one-dimensional direction (here, the Y-axis direction) with respect to the projection optical system PO, to transfer the entire circuit pattern of the reticle R in a step-and-scan method onto each of a plurality of shot regions on the wafer W1 (or wafer W2).

The exposure apparatus 10 is equipped with: a light source device 112 that emits EUV light (light in the soft X-ray region) as illumination light EL; an illumination optical system (not shown) including a bending mirror M that reflects and deflects the illumination light EL from the light source device 112 to cause the light EL to enter the pattern surface (the lower surface (the -Z side surface)) of reticle R at a predetermined incident angle such as around 50 mrad (incidentally, the bending mirror M exists inside a barrel of the projection optical system PO but is actually part of the illumination optical system); a reticle stage RST for holding the reticle R; a projection optical system PO for projecting the illumination light (EUV light) EL, reflected by the pattern surface of the reticle R, perpendicularly with respect to the exposure surface (the upper surface (the +Z side surface) of the wafer W1 (or wafer W2); an alignment system ALG; a wafer stage apparatus 100 that includes a wafer stage WST1 for holding the wafer W1 and a wafer stage WST2 for holding the wafer W2; and the like. In this embodiment, although omitted in the drawings, the reticle stage RST, projection optical system PO, and wafer stages WST1 and WST2, and the like are actually contained within a vacuum chamber (not shown).

As the light source device 112, a laser-excited plasma light source is used as an example. The laser-excited plasma light source irradiates a high-intensity laser beam at an EUV light emitting material (target), which excites the target to a high-temperature plasma state, and utilizes EUV light, ultraviolet light, visible light, and light of other wavelengths that are emitted as the target cools down. In this embodiment, EUV light having a wavelength of 5 to 20 nm, for example, 11 nm is mainly used as the illumination light EL.

The illumination optical system includes an illumination mirror, a wavelength selecting window or the like (neither is shown), and the bending mirror M or the like. The illumination light EL, emitted by the light source device 112 and passed through the illumination optical system (EUV light EL reflected by the bending mirror M discussed above), is shaped into an arc-shaped slit illumination light and illuminates the pattern surface of the reticle R.

The reticle stage RST is situated on a reticle stage base 132 situated along the X-Y plane, and is levitated and supported above the reticle stage base 132 by a magnetic levitational force generated by, for example, a magnetic levitational type two-dimensional linear actuator that constitutes a reticle-stage driving system 134. The reticle stage RST is driven at a predetermined stroke in the Y-axis direction by the driving force generated by the reticle-stage driving system 134, and is driven small amounts in the X-axis direction and a θz direction (rotation direction about the Z-axis). Further, the reticle stage RST can also be driven a small amount in the Z-axis direction and inclined directions with respect to the X-Y plane (the θx direction being the rotation direction about the X-axis and the θy direction being the rotation direction about the Y-axis), by adjustment of the magnetic levitational force generated in multiple locations by the reticle-stage driving system 134.

A reticle holder of an electrostatic-type chuck (or mechanical-type chuck, not shown) is disposed on the lower surface side of the reticle stage RST, and the reflective reticle R is held by the reticle holder. The reticle R is composed of a thin plate of a silicon wafer, quartz, low-expansion glass, or the like, and on the -Z side surface (pattern surface) of the reticle, a multilayer film for reflecting EUV light is formed, which are made up of, for example, approximately 50 pairs of a film of molybdenum (Mo) and a film of beryllium (Be) alternately layered at a period of approximately 5.5 nm. The multilayer film has a reflectance of approximately 70% for incident EUV light having a wavelength of 11 nm. Similar types of multilayer films are formed on the reflective surfaces of the bending mirror M and of the other mirrors in the illumination-optical system.

Over the multilayer film on the pattern surface of the reticle R, for example, a layer of nickel (Ni) or aluminum (Al) is coated on the entire surface as an absorbing layer, and the patterning is applied to the absorbing layer to define a circuit pattern.

The position (including θz rotation) in the X-Y plane of the reticle stage RST (reticle R) is continually detected at a resolution of approximately 0.5 to 1 nm, for example, by a reticle laser interferometer (hereinafter referred to as "reticle interferometer") 182R that projects a laser beam onto a reflective surface disposed (or formed) on the reticle stage RST.

The position of the reticle R in the Z-axis direction is measured by a reticle focus sensor (not shown) that is composed of a multipoint focal-position-detecting system as disclosed in, for example, Kokai (Japanese Unexamined Patent Application Publication) No. 06-283403 (corresponding to U.S. Patent No. 5,448,332) and the like.

Measurement values of the reticle interferometer 182R and the reticle-focus sensor are supplied to a controller (not shown), and the reticle stage RST is driven by the controller, via the reticle-stage driving system 134, based on the measurement values.

As the projection optical system PO, a catoptric system that has a numerical aperture (NA) of 0.1 and is composed of only reflecting optical elements (mirrors) is used, and the projection optical system PO having a projection magnifying power of, for example, 1/4 times is used in this case. Consequently, EUV light EL reflected by the reticle R and including information concerning the pattern defined on the reticle R, is projected onto the wafer W1 (W2), and accordingly the pattern on the reticle R is reduced 1/4 times, and transferred onto the wafer W1 (W2).

The projection optical system PO is configured including a mirror tube 117 and six reflective optical elements (mirrors), for example, situated inside the mirror tube 117. On the upper wall (+Z side wall) of the mirror tube 117, a rectangular opening 117b vertically penetrating the upper wall is formed, and on the -Y side wall, an opening 117a is formed. The bending mirror M constituting the illumination optical system discussed above is also situated inside the mirror tube 117.

The off-axis alignment system ALG is disposed at a position located a predetermined distance to the +Y side from the proj ection-optical system PO. As the alignment system ALG, an FIA (Field Image Alignment) alignment sensor is used that irradiates broadband light at an alignment mark (or a field-image meter FM1 (FM2)) on the wafer W1 (W2), receives the light reflected from the alignment mark, and performs mark detection by image processing. Alternatively to the FIA alignment sensor, as the alignment system ALG, any of various other components such as an LIA (Laser Interferometric Alignment) alignment sensor, an LSA (Laser Step Alignment) alignment sensor, a scanning-probe microscope such as an AFM (atomic force microscope), or the like can be used.

A wafer focus sensor (not shown), similar to the reticle focus sensor discussed above (not shown), which is disclosed in detail, for example, in Kokai (Japanese Unexamined Patent Application Publication) No. 06-283403 (corresponding to U.S. Patent No. 5,448,332), is integrally attached to the mirror tube 117 of the projection optical system PO via a holding device. The wafer focus sensor measures the position in the Z-axis direction and the inclination of the surface of the wafer W1 or W2, with the mirror tube 117 of the projection optical system PO as a reference.

The wafer stage apparatus 100 includes a base BS, the wafer stage WST1 that is situated above the base BS and moves in the X-Y plane holding the wafer W1, the wafer stage WST2 that moves in the X-Y plane holding the wafer W2, a driving system that drives the stages WST1 and WST2, an interferometer system that measures the positions of the stages WST1 and WST2, and the like.

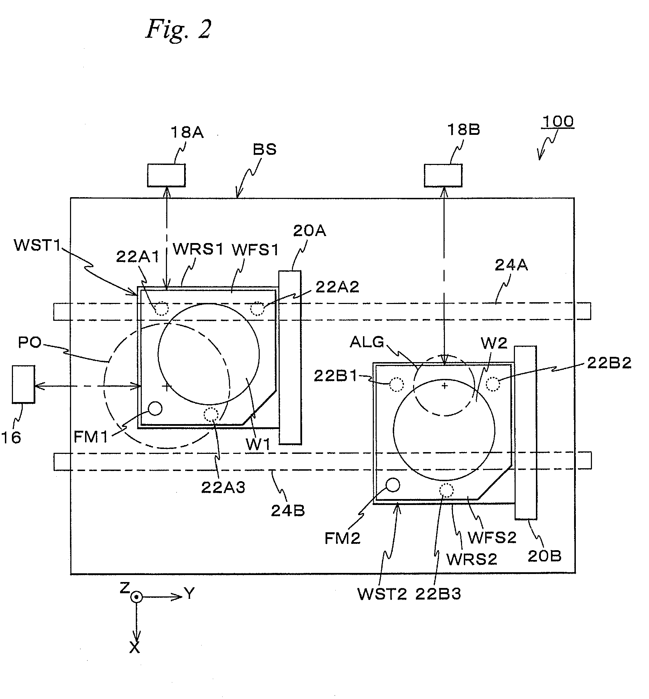

As can be seen when referring together to FIG. 1 and FIG. 2 that shows a state where the wafer stage apparatus 100 is viewed from above, on the base BS, two power-transmitting, waste-heat frames 24A and 24B that extend lengthwise in the Y-axis direction are disposed at a predetermined interval from each other in the X-axis direction. Viewed from the +X direction toward the -X direction, the power-transmitting, waste-heat frames 24A and 24B each have an inverted U-shape, and their one ends and the other ends are fixed to one end surface and the other end surface of the base BS in the Y-axis direction, respectively. Of these power-transmitting, waste-heat frames 24A and 24B, the lower surface of the portion parallel to the X-Y plane, positioned over the base BS, is maintained at a predetermined gap relative to the uppermost surface of the wafer stages WST1 and WST2. The specific configuration, function, and the like of the power-transmitting, waste-heat frames 24A and 24B will be discussed in further detail below.

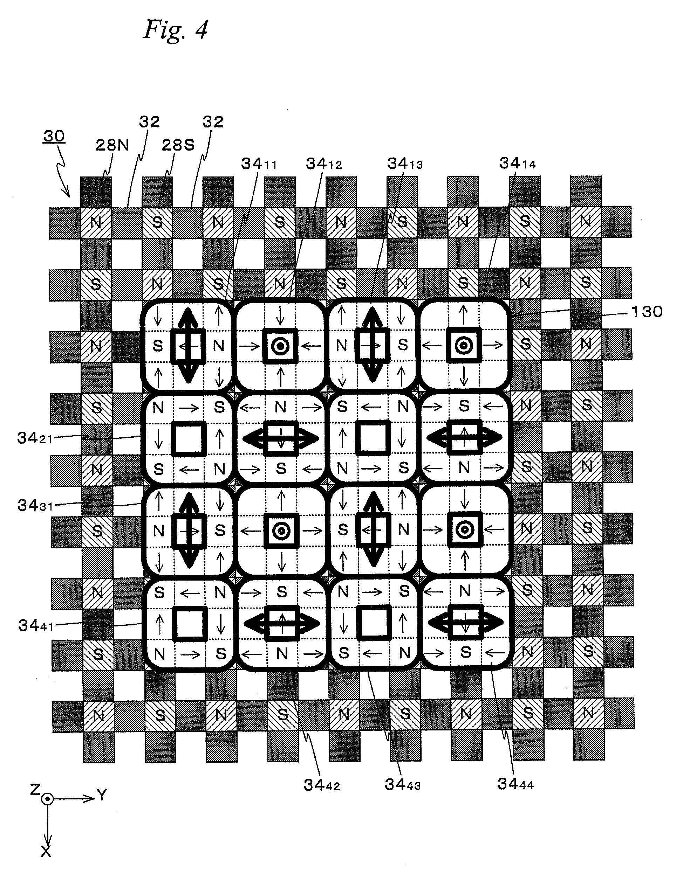

As shown in FIG. 1, a magnet unit 30 including a plurality of permanent magnets is disposed in a state of being embedded on the upper surface side of the base BS. The magnet unit 30 constitutes part of a planar motor to be discussed below, and as can be seen from the plan view in FIG. 4, includes permanent magnets 28N and 28S that are produced by, for example, sintering rare-earth materials, and are magnetized in the Z-axis direction (perpendicularly magnetized). The +Z side surface of the permanent magnet 28N is its N-pole face, and the +Z side surface of the permanent magnet 28S is its S-pole face. The permanent magnets 28N and 28S are alternately arrayed in a matrix at predetermined intervals along the X-axis direction and Y-axis direction. The permanent magnets 28N and 28S each have a roughly square shape in planar view (viewed from above) and each have an identical size.

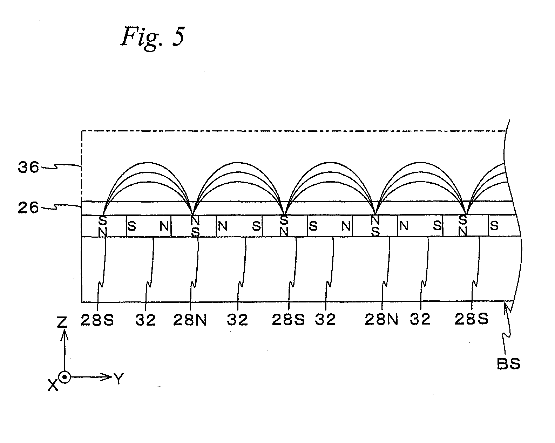

The magnet unit 30 also includes permanent magnets (interpolation magnets) 32 magnetized in the X-axis direction or Y-axis direction (horizontally magnetized). The interpolation magnets 32 are disposed between adjacent permanent magnets 28N and 28S, and as can be seen from FIG. 5 showing the base BS viewed from the +X side, the surface of the interpolation magnet 32 contacting the permanent magnet 28N is its N-pole face, and the surface of the interpolation magnet contacting the permanent magnet 28S is its S-pole face. Each interpolation magnet 32 has a roughly square shape in planar view (viewed from above) and has the same size as the permanent magnets 28N and 28S. With such a magnet unit 30, a magnetic circuit can be formed (see FIG. 5) in which magnetic flux sequentially circles in the permanent magnet 28N, the permanent magnet 28S, and the interpolation magnet 32, and the interpolation magnets 32 can intensify the magnetomotive force.

As shown in FIG. 5 (and Fig. 1), on the upper surface of the base BS, a protective plate 26 composed of a nonmagnetic material is disposed in a state of covering the magnet unit 30 from above. The protective plate 26 prevents direct contact between the wafer stages WST1 and WST2, and the permanent magnets 28N, 28S and 32, and thus prevents damage to the permanent magnets 28N, 28S and 32.

As shown in FIG. 2, the wafer stage WST1 is equipped with a coarse movement stage WRS1 made up of a plate-shaped member having a roughly rectangular shape in planar view (viewed from above), and a fine movement stage WFS1 mounted on the coarse movement stage WRS1.

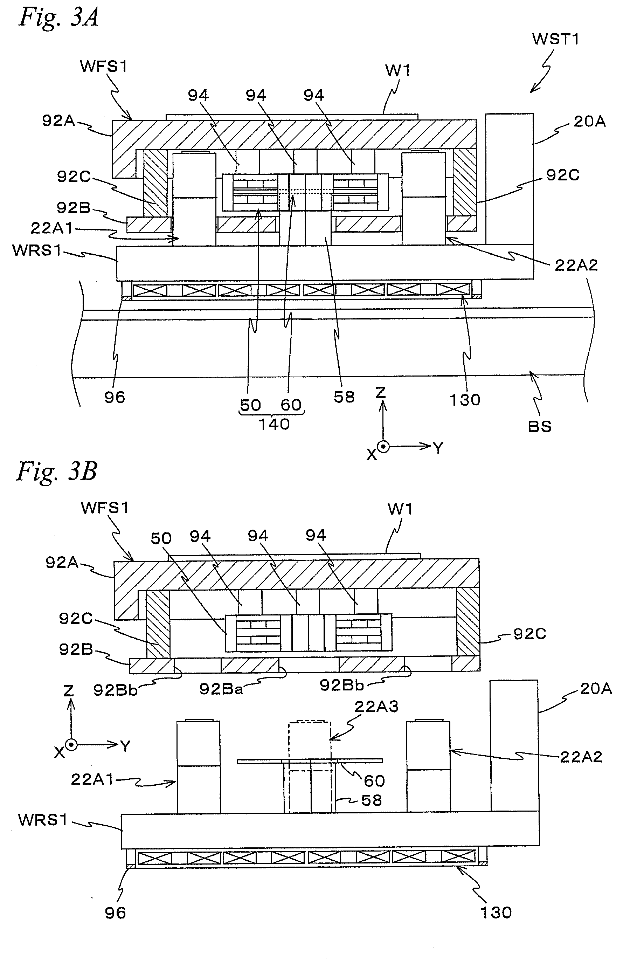

As can be seen from FIG. 3A showing a partial cross-section of the wafer stage WST1 viewed from the +X direction, and from FIG. 3B showing a disassembled state of the wafer stage WST1 in FIG. 3A, an armature unit 130 that constitutes part of a planar motor that drives the coarse movement stage WRS1 (wafer stage WST1) in the X-Y two-dimensional plane is disposed on the lower surface (-Z side surface) of the coarse movement stage WRS1.

As shown in FIG. 4, the armature unit 130 includes sixteen armature coils 34₁₁-34₄₄. Electric current can be supplied independently to each of these armature coils 34₁₁-34_{44.} As shown in FIG. 4, a size of each of armature coils 34₁₁-34₄₄ is set so that the length of one side is equal to the total length of permanent magnets 28N, 28S and 32.

In this embodiment, a planar motor is configured of the armature unit 130 and the magnet unit 30 disposed inside the base BS. By supplying electric current to the armature coils 34₁₁, 34₁₃, 34₃₁ and 34₃₃, a driving force in the X-axis direction can be imposed on the armature unit 130, when the armature unit 130 is at the position as shown in FIG. 4. Also, by supplying electric current to the armature coils 34₂₂, 34₂₄, 34₄₂ and 34₄₄, a force in the Y-axis direction can be imposed on the armature unit 130. Further, by supplying electric current to the armature coils 34₁₂, 34₁₄, 34₃₂, 34₃₄, a force in the Z-axis direction can be imposed on the armature unit 130.

In this embodiment, even in cases other than when the armature unit 130 is at the position shown in FIG. 4, by calculating the magnitude and direction of the electric current to be supplied to each coil according to the position of the wafer stage WST1 and by varying the electric current according to the calculation results, a driving force in a desired direction can be imposed on the armature unit regardless of the position of the wafer stage WST1.

Consequently, in the controller (not shown), it is possible to drive the wafer stage WST1 in the desired direction by controlling the electric current supplied to each coil, based on the detection results of the interferometer unit (discussed below) that detects the position of the wafer stage WST1, and on the direction and velocity of movement of the wafer stage WST1.

In this embodiment, a magnetic body member 96 for generating magnetic attraction between the permanent magnets 28N and 28S is affixed on the lower end of the armature unit 130, as shown in FIG. 3A. A gap of approximately several micrometers is maintained between the coarse movement stage WFS1 and the upper surface of the base BS by a balance among the magnetic attraction between the magnetic body member 96 and the permanent magnets 28N and 28S; the empty weight of the wafer stage WST1; and the levitational force produced by the planar motor.

As shown in FIGS. 3A and 3B, the fine movement stage WFS1 includes a table 92A that supports the wafer W1 from the lower side via a wafer holder (not shown), and a plate-shaped member 92B that is suspended from and supported by multiple (e.g. three) hanging support members 92C on the lower surface side of the table 92A.

On the upper surface side of the table 92A, as shown in FIGS. 1 and 2, the field-image meter FM1 is disposed for performing measurement of the relative positional relationship between the location, on the wafer surface, at which a pattern formed on reticle R is projected and the alignment system ALG (so called "baseline measurement"), and the like. The field-image meter FM1 is equivalent to a reference mark plate of a conventional DUV exposure apparatus. Further, a reflective surface is formed on each of the -Y side surface and -X side surface of the fine movement table 92A, by mirror finishing.

As shown in FIGS. 3A and 3B, a fine movement apparatus 140 for finely driving the fine movement stage WFS1 in the X-Y plane, and empty-weight-canceling mechanisms 22A1-22A3 are disposed between the fine movement stage WFS1 and the coarse movement stage WRS1.

The fine movement apparatus 140 includes a movable element 50 suspended from and supported by multiple (e.g. three) of the hanging support members 94 from the table 92A of the fine movement stage WFS1, and a fixed element 60 disposed via a support member 58 on the upper surface of the coarse movement stage WRS1. In the wafer stage WST1 in an assembled state (the state in FIG. 3A), the movable element 50 and the fixed element 60 are engaged (the fixed element 60 is inserted in the movable element 50), and the support member 58, which supports the fixed element 60, is inserted in an opening 92Ba (see FIG. 3B) formed in the plate-shaped member 92B of the fine movement stage WFS1.

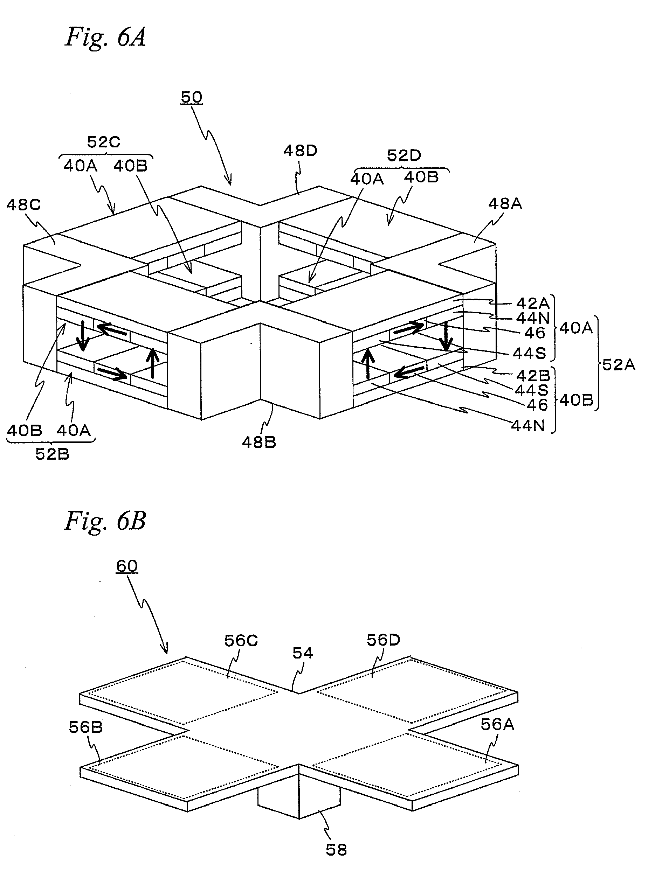

As shown in FIG. 6A showing the movable element 50 in a perspective view, the movable element 50 has a roughly X shape (cross shape) in planar view (viewed from above), and includes four magnet units 52A, 52B, 52C and 52D, and four holding members 48A, 48B, 48C and 48D that are each L-shaped in planar view (viewed from above) and hold the magnet units 52A-52D in a predetermined positional relationship.

Each of the magnet units 52A-52D is equipped with a pair of magnetic pole portions 40A and 40B with a predetermined distance therebetween in the Z-axis direction, as representatively shown with the magnet unit 52A in FIG. 6A. One magnetic-pole portion 40A includes a flat plate-shaped member 42A, vertically magnetized permanent magnets 44N and 44S disposed on the lower surface of the plate-shaped member 42A, and a horizontally magnetized permanent magnet (interpolation magnet) 46 disposed between the permanent magnets 44N and 44S. The lower surface (-Z side surface) of the permanent magnet 44N is its N-pole face, and the lower surface (-Z side surface) of the permanent magnet 44S is its S-pole face. Of the permanent magnet (interpolation magnet) 46, the surface in contact with the permanent magnet 44N is its N-pole face, and the surface in contact with the permanent magnet 44S is its S-pole face. The operation of the interpolation magnet 46 is similar to that of the interpolation magnet 32 of the magnet unit 30 constituting the planar motor discussed above.

The other magnetic pole portion 40B is vertically and horizontally symmetrical to the magnetic pole portion 40A, but has the similar configuration. In other words, the magnetic pole portion 40B includes a plate-shaped member 42B and permanent magnets 44N, 44S and 46, and further the upper surface (+Z side surface) of the permanent magnet 44N is its N-pole face, and the upper surface (+Z side surface) of the permanent magnet 44S is its S-pole face, and of the permanent magnet (interpolation magnet) 46, the surface in contact with the permanent magnet 44N is its N-pole face and the surface in contact with the permanent magnet 44S is its S-pole face.

With the magnet unit 52A configured as is described above, a magnetic circuit as shown by the bold arrows in FIG. 6A is formed.

The other magnet units 52B-52D have the similar configuration to the one described above, but the magnet unit 52B and the magnet unit 52D are different in that the magnetic pole portion 40A is situated on the lower side (-Z side) and the magnetic pole portion 40B is situated on the upper side (+Z side).

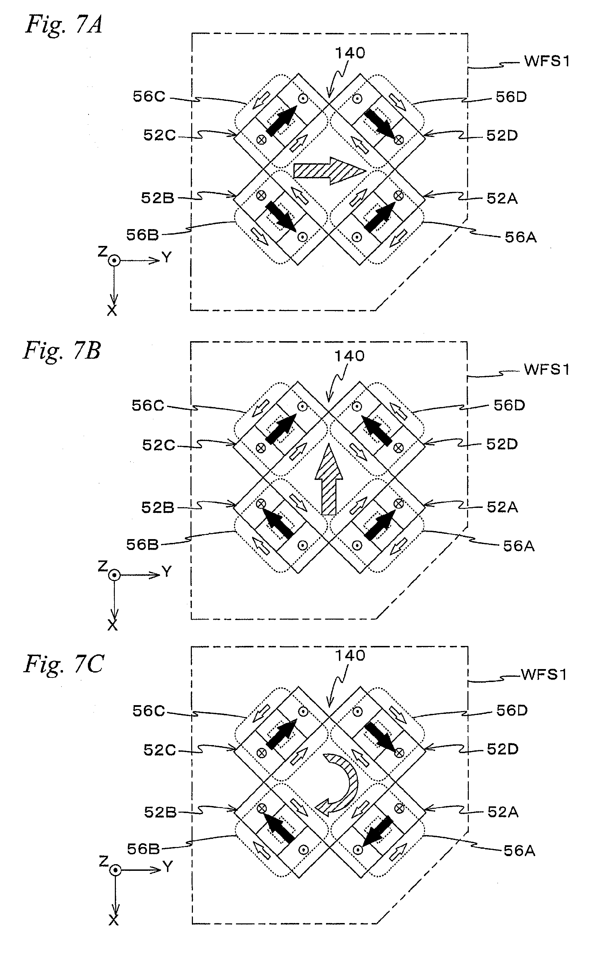

In the movable element 50, the direction in which the magnet units 52A and 52C are aligned and the direction in which the magnet units 52B and 52D are aligned are inclined at a 45-degree angle with respect to the X-axis and Y-axis (see FIGS. 7A-7C).

The fixed element 60 includes a housing 54 having an X-shape (cross shape) in planar view (viewed from above), and four armature coils 56A-56D disposed within the housing 54, as shown in FIG. 6B that shows the fixed element 60 in a perspective view.

The armature coils 56A-56D are inserted between the magnetic pole portions 40A and 40B of the magnet units 52A-52D, respectively. Due to the electromagnetic interaction of the electric current flowing through each armature coil and the magnetic field generated by each magnet unit, as shown in FIGS. 7A-7C, a force can be generated in a direction inclined at a 45-degree angle relative to the X-axis and Y-axis (direction shown with black arrows).

With the fine movement apparatus 140 configured in this way, as shown in FIG. 7A, by supplying a clockwise electric current of a predetermined magnitude to the armature coils 56A and 56D (in FIG. 7A, the direction of the electric current is indicated by outlined arrows) and supplying a counterclockwise electric current of a predetermined magnitude to the armature coils 56B and 56C, a driving force in the direction shown by the black arrows is generated due to electromagnetic interaction between the electric current flowing through each armature coil and the magnetic field formed by each magnet unit. From the resultant of these driving forces, a driving force in the direction (+Y direction) indicated by a hatched arrow is imposed on the movable element 50 (fine movement stage WFS1). Further, by supplying the respective coils with electric currents in directions opposite to those noted above, a driving force in the -Y direction can be caused to act on the movable element 50 (fine movement stage WFS1).

As shown in FIG. 7B, when a clockwise electric current is supplied to the armature coils 56A and 56B and a counterclockwise electric current is supplied to the armature coils 56C and 56D, a driving force in the direction indicated by black arrows is generated by the electromagnetic interaction between the electric current flowing through each armature coil and the magnetic field formed by each magnet unit. Due to the resultant of these driving forces, a driving force in the direction (-X direction) indicated by a hatched arrow is imposed on the movable element 50 (fine movement stage WFS1). Further, by supplying the respective coils with electric currents in directions opposite to those noted above, a driving force in the +X direction can be imposed on the movable element 50 (fine movement stage WFS1).

As shown in FIG. 7C, when a counterclockwise electric current is supplied to the armature coils 56A and 56C and a clockwise electric current is supplied to the armature coils 56B and 56D, a driving force in the direction indicated by black arrows is generated by the electromagnetic interaction between the electric current flowing through each armature coil and the magnetic field formed by each magnet unit. Due to the resultant of these driving forces, a driving force in the direction (rotary direction around the Z-axis (clockwise)) indicated by the hatched arrow is imposed on the movable element 50 (fine movement stage WFS1). Further, by supplying the respective coils with electric currents in directions opposite to those noted above, a driving force in the opposite rotary direction around the Z-axis (counterclockwise) can be imposed on the movable element 50 (fine movement stage WFS1).

Returning to FIGS. 3A and 3B, the three empty-weight-canceling mechanisms 22A1-22A3 (in FIG. 3A, the empty-weight-canceling mechanism 22A3 is omitted for the sake of simplicity) support the fine movement stage WFS1 in a non-contacting manner at three points on the coarse movement stage WRS1, and each empty-weight-canceling mechanism is configured including a driving mechanism (voice coil motor), or the like. With each of these mechanisms, the fine movement stage WFS1 is finely driven in directions of three degrees of freedom, which are the Z-axis direction, the θx direction (rotation about the X-axis), and the θy direction (rotation about the Y-axis). The empty-weight-canceling mechanisms 22A1-22A3 disposed in a state of penetrating openings 92Bb formed in the plate-shaped member 92B of the fine movement stage WFS1.

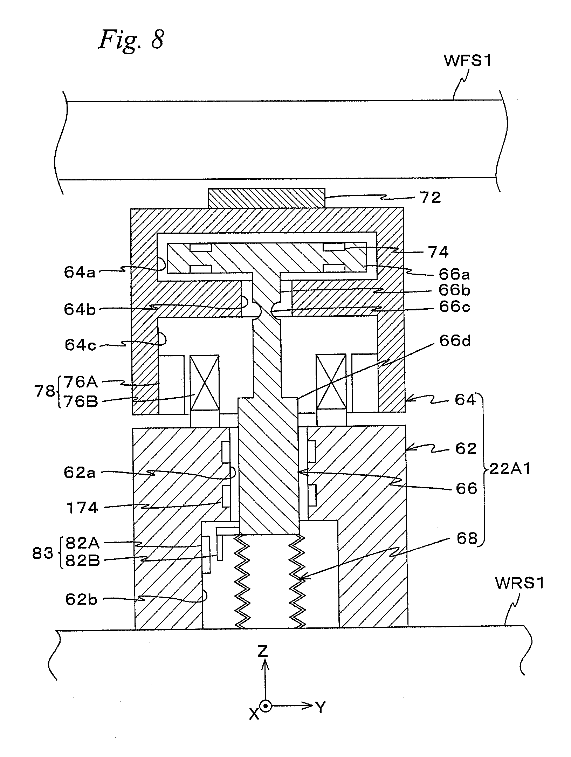

Of the empty-weight-canceling mechanisms 22A1-22A3, one empty-weight-canceling mechanism 22A1 is representatively focused on, and its configuration and the like will be explained next, referring to FIG. 8. FIG. 8 shows a vertical sectional view of the empty-weight-canceling mechanism 22A1.

As can be seen from FIG. 8, the empty-weight-canceling mechanism 22A1 includes a first member 62 fixed to the upper surface of the coarse movement stage WRS1, a second member 64 disposed above the first member 62, a third member 66 disposed inside the first member 62 and the second member 64, and a bellows 68 disposed in a state of connecting the lower end surface (-Z side surface) of the third member 66 and the upper surface (+Z side surface) of the coarse movement stage WRS1.

The first member 62 is composed of a member whose outer shape is roughly column-shaped, and a circular recessed portion 62b of a predetermined depth is formed on the center of the lower end surface thereof, and a circular through-hole 62a penetrating to the upper surface of the first member 62 is formed in the central portion of the inner bottom face (upper surface) of the circular recessed portion 62b. Specifically, a stepped through-hole is formed by the circular recessed portion 62b and the through-hole 62a.

The second member 64 is composed of a member whose outer shape is roughly column-shaped, and a recessed portion 64c having a predetermined depth and a circular shape in cross section is formed in the center of the lower end surface thereof. Further, a chamber 64a, which has a circular shape in cross section having substantially the same diameter as the recessed portion 64c is formed at a position a predetermined distance away on the +Z side from the recessed portion 64c. A circular hole 64b, connecting the inner bottom face (upper surface) of the recessed portion 64c and inner lower surface of the chamber 64a, is formed in the second member 64. A vacuum preload type (differential pumping type) aerostatic bearing 72 is fixed on the upper surface of the second member 64 (specifically, the upper surface of the empty-weight-canceling mechanism 22A1), and the fine movement stage WFS1 is supported in a non-contacting manner by the empty-weight-canceling mechanism 22A1 due to the balance of the static pressure generated by the vacuum preload type aerostatic bearing 72 and the empty weight of the fine movement stage WFS1. To maintain a predetermined gap between the second member 64 and the fine movement stage WFS1, a mechanism generating a magnetic repulsive force may be employed instead of the vacuum preload type aerostatic bearing 72.

The third member 66 has a tip portion 66a having a circular plate shape that is slightly smaller than the chamber 64a of the second member 64, a first shaft portion 66b disposed on the lower surface center portion of the tip portion 66a, and a second shaft portion 66d disposed on the lower end of the first shaft portion 66b and having a diameter greater than that of the first shaft portion 66b. As a whole, the third member 66 has a T shape in the Y-Z cross-section (as well as in the X-Z cross-section).

In the third member 66, a hinge portion 66c is formed on the side that is slightly upper from the center in the height-wise direction of the first shaft portion 66b, and the upper side portion than the hinge portion 66c can be oscillated relative to the lower side portion.

An air pad mechanism 74 is disposed on the upper surface and lower surface of the tip portion 66a. The air pad mechanism 74 is not detailed in the drawing, but actually includes a gas exhaust opening for exhausting gas; a low vacuum suction opening for drawing gas, exhausted from the gas exhaust opening, at low vacuum (e.g., approximately 10² to 10³ Pa); and a high vacuum suction opening for drawing gas at high vacuum (e.g., approximately 10⁻² to 10⁻³ Pa). The supply of gas and the like to the air pad mechanism 74 is performed by a gas supply apparatus (not shown) via a conduit line (not shown) formed in the second member 64 and first member 62 and via a gas supply pipe (not shown) connected with the first member 62. With the air pad mechanism 74, a predetermined clearance (e.g. approximately several micrometers) is formed between the tip portion 66a of the third member 66 and the upper and lower wall surfaces of the chamber 64a of the second member 64.

Multiple air pad mechanisms 174, similar to those described above, are also disposed on the inner wall surface of the first member 62 that is opposite to the second shaft portion 66d of the third member 66. Thus, a predetermined clearance (e.g. approximately several micrometers) is formed between the inner wall surface of the first member 62 and the second shaft portion 66d of the third member 66.

A gas supply pipe (not shown) is connected to the bellows 68, and gas is supplied from a gas supply apparatus (not shown) via the gas-supply pipe, and thus, a predetermined pressure is maintained in the interior of the bellows 68.

Furthermore, a voice coil motor 78 is disposed between the first member 62 and the second member 64. The voice coil motor 78 includes a fixed element 76B including an armature coil fixed on the upper surface of the first member 62, and a movable element 76A having a permanent magnet fixed on the side wall interior surface of the recessed portion 64c of the second member 64.

Using the voice coil motor 78, the positional relationship in the Z-axis direction between the first member 62 and the second member 64 (and third member 66) can be varied.

An encoder 83 is disposed between the third member 66 and the first member 62. The encoder 83 includes a scale 82B that is disposed on the lower-end portion of the third member 66; and a sensor head 82A that is disposed on the side wall interior surface of the recessed portion 62b of the first member 62, and has an irradiation system for irradiating a light beam toward the scale 82B and a light-receiving element for receiving light reflected by the scale 82B. Using the encoder 83, the positional relationship in the Z-axis direction between the first member 62 and third member 66 can be detected.

The other empty-weight-canceling mechanisms 22A2 and 22A3 are configured similarly to the empty-weight-canceling mechanism 22A1 described above.

With the empty-weight-canceling mechanisms 22A1-22A3 configured in this way, the fine movement stage WFS1 can be supported by the bellows 68 constituting each of the empty-weight-canceling mechanisms 22A1-22A3, with low rigidity at three points via the third member 66, second member 64, and air pad mechanism 72. In this case, the rigidity of the bellows 68 is not completely zero, and therefore based on the measurement results of the encoder 83, the voice coil motor 78 can be driven finely so as to negate the rigidity of the bellows 68. Further, using the controller (not shown), the electric current for Z-axis direction driving can be supplied in combination with the electric current for negating the rigidity of the bellows, to the coil of the fixed element 76B of the voice coil motor 78, in order to apply a driving force in the Z-axis direction on the fine movement stage WFS1.

Returning to FIG. 2, a power-receiving, heat-dissipating arm 20A is disposed on the +Y side end portion of the upper surface of the coarse movement stage WRS1. As can be seen from FIG. 2, the length (width) of the power-receiving, heat-dissipating arm 20A in the X-axis direction is set longer (wider) than the distance between the power-transmitting, waste-heat frames 24A and 24B discussed above, and therefore, part of the upper surface of the power-receiving, heat-dissipating arm 20A is constantly in a state of confronting the lower surface of at least one of the power-transmitting, waste-heat frames 24A and 24B.

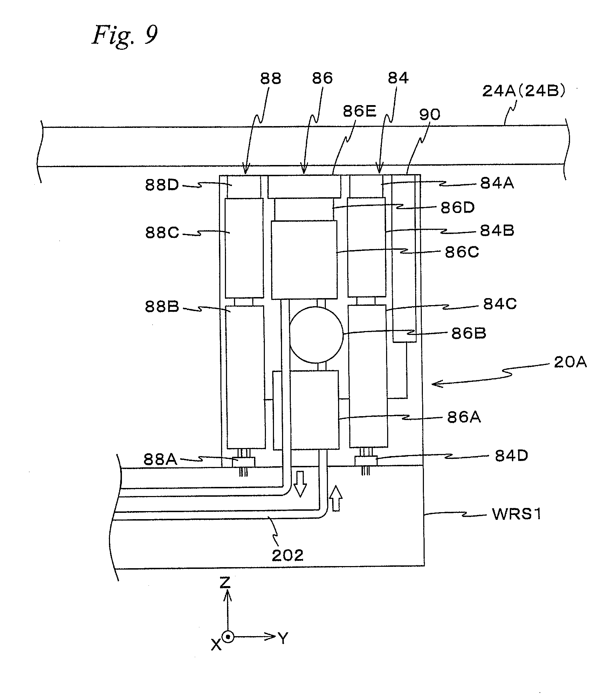

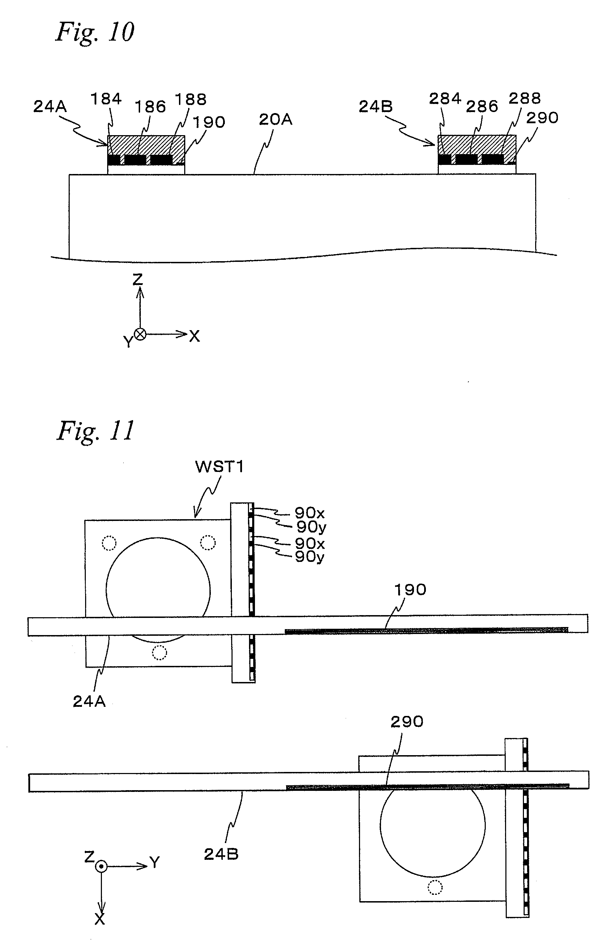

The internal configuration of the power-receiving, heat-dissipating arm 20A is described here together with the configuration of the power-transmitting, waste-heat frames 24A and 24B, with reference to FIGS. 9 and 10, and other drawings. FIG. 9 is a view showing the power-receiving, heat-dissipating arm 20A as viewed from the +X side with the internal configuration, and FIG. 10 is a view showing an X-Z cross-section of the power-transmitting, waste-heat arms 24A and 24B, along with the power-receiving, heat-dissipating arm 20A.

As shown in FIG. 9, a liquid-temperature-regulating system 86, an electric-power-input system 84, a signal-transmitting system 88, and a head section 90 constituting the encoder are disposed inside the power-receiving, heat-dissipating arm 20A.

The liquid-temperature-regulating system 86 is arranged in the vicinity of the heat source of the coarse movement stage WRS1 (e.g. , the armature coils of the armature unit 130 constituting the planar motor, the armature coils 56A-56D constituting the fine movement mechanism 140, the voice coil motors included in the empty-weight-canceling mechanisms 22A1-22A3, and the like). The liquid-temperature-regulating system 86 includes a feedback section 86A to which is connected one end of a coolant conduit line 202 inside of which a coolant liquid passes through; a circulating pump 86B; a temperature-regulating section 86C which is disposed on the side of the circulating pump 86B opposite to the feedback section 86A and to which the other end of the coolant conduit line 202 is connected; a Peltier element 86D disposed in a state in contact with the temperature-regulating section 86C; and a heat-dissipating section 86E disposed in a state in contact with the surface of the Peltier element 86D opposite to the temperature-regulating section 86C.

The temperature-regulating section 86C is a tank capable of containing a predetermined volume of coolant liquid, and the coolant liquid contained in the temperature-regulating section 86C is cooled to a predetermined temperature by the Peltier element 86D. The heat-dissipating section 86E has an upper surface that is substantially parallel to the X-Y plane (parallel to the X-Y plane when wafer stage WST is situated on the base BS), and discharges heat on the surface of the Peltier element 86D on the side opposite to the temperature-regulating section 86c, to the outside through radiation. The heat-dissipating section 86E actually extends over the entire area in the X-axis direction (i.e., direction orthogonal to the page surface) of the power-receiving, heat-dissipating arm 20A.

Meanwhile, as shown in FIG. 10, inside one power-transmitting, waste-heat frame 24A, a waste-heat section 186 for absorbing heat from the heat-dissipating section 86E is disposed. The waste-heat section 186 extends over the entire area in the Y-axis direction of the power-transmitting, waste-heat frame 24A. Consequently, in a state where the power-receiving, heat-dissipating arm 20A and the power-transmitting, waste-heat frame 24A face each other in a vertical direction, part of the waste-heat section 186 and part of the heat-dissipating section 86E continually face each other. For example, since coolant is supplied to the waste-heat section 186, heat radiated from the heat-dissipating section 86E can efficiently be absorbed. The similar type of waste-heat section 286 is disposed inside the other power-transmitting, waste-heat frame 24B.

Returning to FIG. 9, the electric-power-input system 84 includes a receiver 84A, a power-converting section 84B, an A/D converter-amplifier section 84C, and a connector 84D. A coil for receiving electric power wirelessly is disposed in the receiver 84A. The coil extends over the entire area in the X-axis direction (the direction orthogonal to the page surface) of the power-receiving, heat-dissipating arm 20A.

Meanwhile, one power-transmitting, waste-heat frame 24A shown in FIG. 10 incorporates a transmitter 184 including a transmitting coil. In a state where the transmitting coil inside this transmitter 184 and the receiving coil inside the receiver 84A face each other in a vertical direction, electric power supplied from an electric-power-supply apparatus (not shown) can be transmitted wirelessly between the transmitting coil and the receiving coil. Since such a wireless power-transmission method is disclosed in Kokoku (Japanese Examined Patent Application) No. 05-059660, Kokai (Japanese Unexamined Patent Application Publication) No. 58-115945 and the like, its description is omitted herein. The other power-transmitting, waste-heat frame 24B also incorporates the similar type of transmitter 284 including a transmitting coil, and in a state where the transmitting coil in the transmitter 284 and the receiving coil in the receiver 84A face each other in a vertical direction, wireless electric-power transmission can be made between the transmitting coil and the receiving coil.

Thus, electric power supplied from the power-transmitting, waste-heat frame 24A or 24B and received by the receiver 84A of the electric-power-input system 84 in FIG. 9 is converted to electric current in the power-converting section 84B, and then undergoes analog-to-digital (A/D) conversion and amplification in the A/D converter-amplifier section 84C, and the amplified power is supplied via the connector 84D to the coils of the driving mechanism for driving the coarse movement stage WRS1 (e.g., coils 34₁₁-34₄₄ constituting the armature unit 130 of the planar motor, the coils included in the fixed element of the voice coil motors 78 constituting the empty-weight-canceling mechanism 22A1-22A3, and the armature coils 56A-56D included in the fine movement mechanism 140, and the like). This electric current is also supplied to the Peltier element 86D and the pump 86B constituting the liquid-temperature-regulating system 86 discussed above. If the wafer holder for holding a wafer W1 on the fine movement stage WFS1 is an electrostatic type wafer holder, this electric current also can be supplied to the wafer holder. In this case, the supply of electric current between the coarse movement stage WRS1 and the fine movement stage WFS1 can be performed wirelessly in the power-transmission method discussed above.

The signal-transmitting system 88 includes a connector 88A, an A/D converter-amplifier section 88B, a wireless signal generator 88C, and a transmitter 88D.

As shown in FIG. 10, a receiver 188 corresponding to the transmitter 88D is disposed in one power-transmitting, waste-heat frame 24A, and a receiver 288 is disposed in the other power-transmitting, waste-heat frame 24B.

With the signal-transmitting system 88 and the receiver 188 (or 288), measurement results obtained by the sensor of the field-image meter FM1 or the like disposed on part of the fine movement stage WFS1 are transmitted wirelessly from the transmitter 88D of the signal-transmitting system 88 to the receiver 188 (or 288). In this case, for the signal interchange between the transmitter 88D and receiver 188 (or 288), for example, an infrared beam can be used, or other waves such as radio waves, acoustic waves, or the like can also be used.

The signal-transmitting system 88 can be configured capable of performing both transmission and reception, and the control signal from the controller (not shown) to the wafer stage WST1 can be transmitted via the signal-transmitting system 88 and the receiver 188 (or 288).

The receiver 188 (288) does not to have to extend over the entire area in the Y-axis direction of the power-transmitting, waste-heat frame 24A (24B), but may be extend over a range where the transmitter 88D is positioned when field-image measurement or the like is performed on the wafer stage WST1.

As shown in FIG. 11, in actuality, the head section 90 includes multiple heads 90y for Y-axis direction measurement for measuring positional information in the Y-axis direction, and multiple heads 90x for X-axis direction measurement for measuring positional information in the X-axis direction.

The multiple heads 90y for Y-axis direction measurement are arranged at predetermined intervals in the X-axis direction, and the heads 90x for X-axis direction measurement are arranged at predetermined intervals in locations that do not interfere with the heads 90y.

Corresponding to the heads, a scale 190 is disposed on the bottom face of one power-transmitting, waste-heat frame 24A, and a scale 290 is disposed on the bottom face of the other power-transmitting, waste-heat frame 24B. The scales 190 and 290 are two-dimensional lattices formed with a predetermined period in the X-direction and Y-direction, from the vicinity of the +Y side end portion to the vicinity of the central portion of the power-transmitting, waste-heat frames 24A and 24B, respectively.

With the head section 90 and scales 190 and 290, measurement of the X-axis direction position of the wafer stage WST1 can be performed at a head 90x opposite to the scale 190 or 290, from among the multiple heads for X-axis direction measurement, and measurement of the Y-axis direction position of the wafer stage WST1 can be performed at a head 90y opposite to the scale 190 or 290, from among the multiple heads for Y-axis measurement. The intervals between neighboring heads 90x and the intervals between neighboring heads 90y are set so that position measurement can be performed using the scale 190 (or 290) at the same time. The case of arranging a plurality of heads that constitute the head section 90 has been explained above, but it is alternatively possible to arrange only one head if the head can cover the measurement range.

Returning to FIG. 2, the other wafer stage WST2 has the similar configuration to the wafer stage WST1 discussed above. Specifically, the wafer stage WST2 is equipped with a coarse movement stage WRS2 similar to the coarse movement stage WRS1; and a fine movement stage WFS2 similar to the fine movement stage WFS1 that is mounted on the coarse movement stage WRS2 via three empty-weight-canceling mechanisms 22B1, 22B2 and 22B3 disposed at three locations not on a straight line. A field-image meter FM2 is disposed on the upper surface of the fine movement stage WFS2. Further, a fine movement mechanism, similar to the fine movement mechanism 140 discussed above, is disposed between the coarse movement stage WRS2 and fine movement stage WFS2, and a power-receiving, heat-dissipating arm 20B, similar to the power-receiving, heat-dissipating arm 20A discussed above, is disposed in the vicinity of the +Y side end portion of the coarse movement stage WRS2. In the power-receiving, heat-dissipating arm 20B, as in the power-receiving, heat-dissipating arm 20A discussed above, transfer of heat generated in the wafer stage WST2, wireless transmission of electric power, transmission and reception of signals detected by the field-image meter FM2 on the wafer stage WST2, and detection of the position in the X-Y plane of the wafer stage WST2 can be performed between the power-transmitting, waste-heat frames 24A and 24B.

The interferometer system for detecting the position, in the X-Y plane, of the wafer stages WST1 and WST2 will be explained next.

As shown in FIG. 2, the interferometer system includes an X-axis interferometer 18A that irradiates a length-measuring beam parallel to the X-axis passing through the projection center of the projection optical system PO; a Y-axis interferometer 16 that irradiates a length-measuring beam parallel to the Y-axis passing through the projection center; and an X-axis interferometer 18B that irradiates a length-measuring beam parallel to the X-axis passing through the detection center of the alignment system ALG.

With the interferometer system having such a configuration, in the case when the wafer stage WST1 and the wafer stage WST2 are located at the positions shown in FIG. 2, the length-measuring beam from the X-axis interferometer 18A is irradiated on the mirror-finished reflective surface on the -X side of the fine movement stage WFS1 that constitutes wafer stage WST1, and the length-measuring beam from the Y-axis interferometer 16 is irradiated on the mirror-finished reflective surface on the -Y side of the fine movement stage WFS1. Also, the length-measuring beam from the X-axis interferometer 18B is irradiated on the mirror-finished reflective surface on the -X side of the fine movement stage WFS2 that constitutes wafer stage WST2. In the situation shown in FIG. 2, the length-measuring beam of the interferometer is not irradiated on the mirror-finished reflective surface on the -Y side of the fine movement stage WFS2.

In the case when the positional relationship of the wafer stage WST1 and wafer stage WST2 is opposite to that shown in FIG. 2, the length-measuring beam of the interferometer 18A is irradiated on the -X side reflective surface of the fine movement stage WFS2, the length-measuring beam of the interferometer 16 is irradiated on the -Y side reflective surface, and the length-measuring beam of the interferometer 18B is irradiated on the -X side reflective surface of the fine movement stage WFS1. The interferometers 18A and 18B are multiaxial interferometers having a plurality of length-measurement axes, and therefore, in addition to measurement of positional information in the X-axis direction of the wafer stages WST1 and WST2, measurement of "rolling" (rotation about the Y-axis (θy rotation)) and "yawing" (rotation in the θz direction) can be performed. Also, the interferometer 16 is a multiaxial interferometer, and therefore, in addition to measurement of positional information in the Y-axis direction of the wafer stages WST1 and WST2, measurement of "pitching" (rotation about the X-axis (θx rotation)) and yawing (rotation in the θz direction) can be performed.

The controller (not shown) controls the position, in the X-Y plane, of the fine movement stage WFS1 (or WFS2) with high accuracy, based on the measurement values of the interferometers 18A and 16 during exposure to be discussed below, and controls the position, in the X-Y plane, of the fine movement stage WFS2 (or WFS1) with high accuracy using the measurement values of the interferometer 18B and the head 90y for Y-axis direction measurement constituting the head section 90, during alignment (and during wafer exchange) to be discussed below.

In this embodiment, when a planar motor for driving the coarse movement stages WRS1 and WRS2 is not being used (such as when base BS transport, exposure apparatus assembly, maintenance, or the like is performed), a magnetic-flux leakage preventing plate 36 as shown in FIG. 5 can be arranged so as to cover the upper surface of the base BS.

The magnetic-flux-leakage preventing plate 36 is made of a nonmagnetic material and is a plate used to prevent the magnetic flux generated by the magnet unit 30 from influencing the exterior of the system, and as shown in FIG. 5, is sufficiently thick to cover the magnetic circuit formed by the magnet unit 30.

By arranging the magnetic-flux-leakage preventing plate 36, a situation, in which a tool or the like used by an operator is abruptly attracted to the magnet unit 30 when the planar motor is not being used, can be prevented from occurring, and further, the influence of magnetic flux on medical equipment such as pacemakers or the like, and the influence of magnetic flux on other apparatus used in an exposure apparatus when the base is being transported can be avoided.

Next, a series of operations, including parallel processing operations of an exposure operation to a wafer on one wafer stage and an alignment operation to a wafer on the other wafer stage, and the like, performed by the exposure apparatus 10 of this embodiment, will be described with reference to FIGS. 2 and 12A to 13B.

FIG. 2 shows a state in which the wafer-alignment operation for the wafer W2 on the wafer stage WST2 is being performed in parallel with the exposure operation for the wafer W1 on the wafer stage WST1 being performed .

In advance of the state shown in FIG. 2, when the wafer stage WST2 is at a predetermined loading position, a previously exposed wafer on the wafer stage WST2 is unloaded from the wafer stage WST2, and a new wafer W2 is loaded on the wafer stage WST2 (i.e. wafer exchange is preformed), by a wafer loader (not shown).

Then, while controlling the X-position of the wafer stage WST2 based on measurement values of the interferometer 18B, and meanwhile, also controlling the Y-position of the wafer stage WST2 based on measurement values of a head facing either the scale 190 or the scale 290 of a plurality of the heads 90y for Y-axis position measurement disposed on the wafer stage WST2, the controller (not shown) detects positional information of alignment marks (sample marks) arranged with a plurality of specific shot regions (sample shot regions) on the wafer W2, using the alignment system ALG.

Next, based on these detection results and the position coordinates of the specific shot regions in design, the controller executes EGA (Enhanced Global Alignment) to find the respective array coordinates of all the shot regions on the wafer W2 by a statistical calculation using the least-squares method, as disclosed in, for example, Kokai (Japanese Unexamined Patent Application Publication) No. 61-044429 and the like. Before performing the EGA, the controller also can perform baseline measurement using the field-image meter FM2. In this case, the measurement results of the field-image meter FM2 are wirelessly transmitted from the transmitter disposed on the power-receiving, heat-dissipating arm 20B to the receiver 188 or 288 disposed on the power-transmitting, waste-heat frame 24A or 24B.

During the wafer exchange and alignment operations discussed above, based on detection results obtained by the interferometer 18B and heads 90y (scale 190 or 290), the controller drives the coarse movement stage WRS2 with a long stroke using the planar motor discussed above, and also finely drives the fine movement stage WFS2 using the fine movement mechanism and empty-weight-canceling mechanism 22B1-22B3.

In parallel with the wafer exchange and alignment, a step-and-scan exposure operation is performed on the wafer stage WST1 side, in which an inter-shot stepping operation to move the wafer stage WST1 to an acceleration starting position for exposure of each shot region on the wafer W1 mounted on the wafer stage WST1, based on the results of the wafer alignment that has been already performed; and a scanning exposure operation to relatively scan the reticle R (reticle stage RST) and the wafer W1 (wafer stage WST1) in the Y-axis direction and transfer a pattern formed on the reticle R to the shot region on the wafer W1 via the projection-optical system PO are repeated.

During the step-and-scan exposure operation discussed above, the controller drives the coarse movement stage WRS1 with a long stroke using the planar motor discussed above, and also finely drives the fine movement stage WFS1 in the X, Y, Z, θx, θy and θz directions relative to the coarse movement stage WRS1, using the fine movement mechanism 140 and empty-weight-canceling mechanisms 22A1-22A3. As a matter of course, the measurement results of the wafer focus sensor discussed above are taken into consideration on the driving in the Z, θx, and θy directions.

Because the procedures for the exposure operation itself and the like are similar to those in a conventional scanning stepper, further detailed description thereof will be omitted herein.

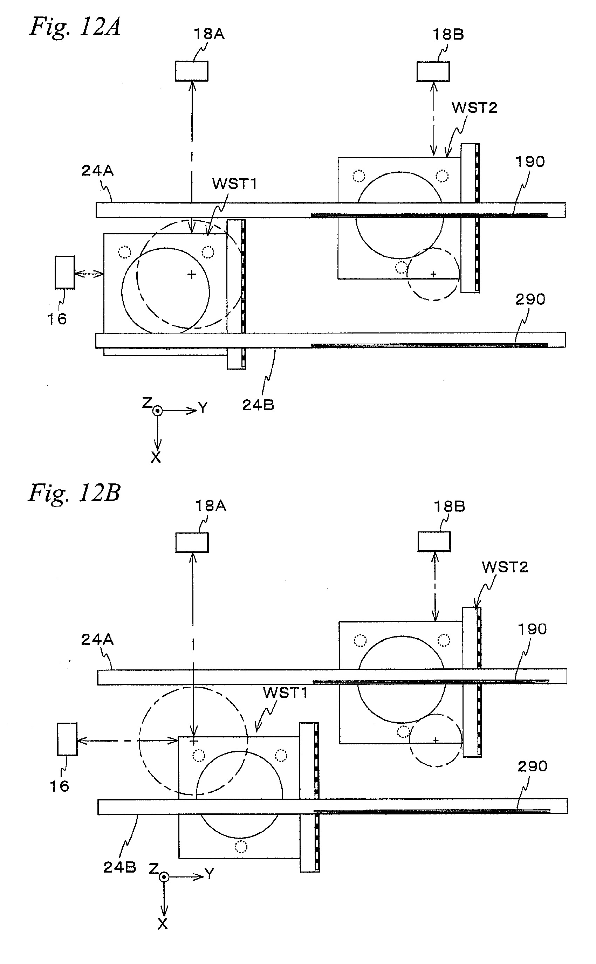

Of the wafer alignment operation to the wafer W2 on the wafer stage WST2 discussed above and the exposure operation to the wafer W1 on the wafer stage WST1, the wafer alignment operation normally finishes first. After completing the wafer alignment, the controller drives the wafer stage WST2 in the -Y direction and -X direction using the planar motor. The wafer stage WST2 is then moved to a predetermined stand-by position (see the position of the wafer stage WST2 in FIG. 12A), and retained at that position.

Then, when the exposure operation to the wafer W1 on the wafer stage WST1 is completed, the controller moves the wafer stage WST1 in the +X direction and +Y direction, using the planar motor. FIG. 12B shows the situation just before the length-measuring beams from the interferometers 18A and 16 stop being incident on the -X side reflective surface and the -Y side reflective surface of the wafer stage WST1, respectively. In this situation, certain of the heads 90x and certain of the heads 90y are situated facing the scale 290, and hence, the controller switches the position measurement of the wafer stage WST1 from the measurement by the interferometers 18A and 16 to the measurement by the heads 90x and 90y. Then, when the length-measuring beam from the interferometer 16 ceases to strike the -Y side reflective surface of the wafer stage WST1, the length-measuring beam from the interferometer 16 begins to strike the -Y side reflective surface of the wafer stage WST2, and hence, the controller switches the measurement of the Y-axis direction position of the wafer stage WST2 to the measurement by the interferometer 16.

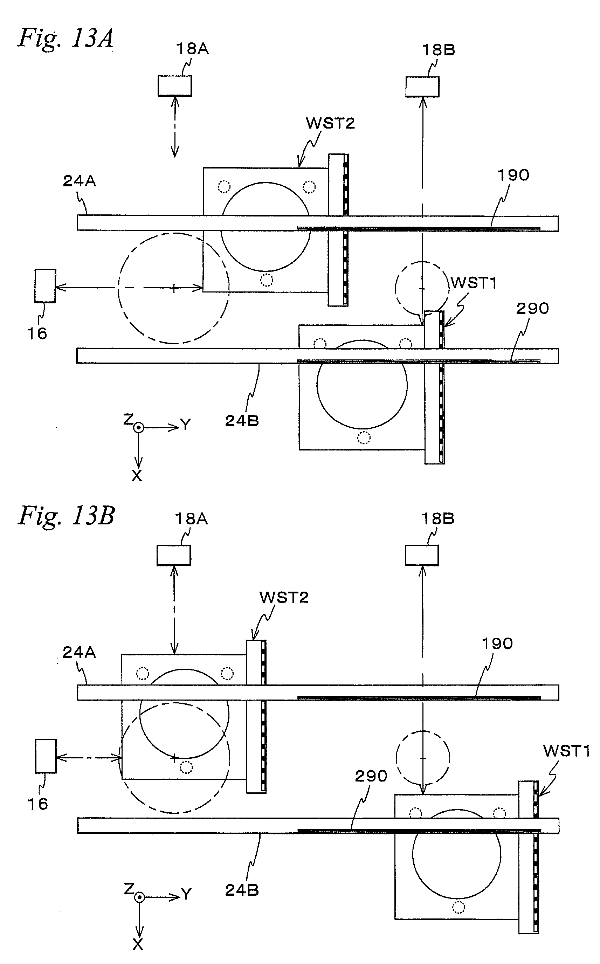

Next, as shown in FIG. 13A, the controller causes the wafer stage WST2 to move to a position directly beneath the projection-optical system PO, using the planar motor, based on the measurement results relating to the Y-axis direction obtained by the interferometer 16 and on the measurement results relating to the X-axis direction obtained by the heads 90x. Since the length-measuring beam from the interferometer 18A is irradiated to the -X-side reflective surface of the fine movement stage WFS2 during this movement, the position measurement, in the X-axis direction, of the wafer stage WST2 are switched from the measurement by the heads 90x to the measurement by the interferometer 18A.

Meanwhile, on the wafer stage WST1 side, at the position shown in FIG. 12B, the position measurement of the wafer stage WST1 has switched from the measurement by the interferometers 18A and 16 to the measurement by the heads 90x for X-axis direction measurement and the heads 90y for Y-axis direction measurement. Thus, while measuring the position in the X-axis direction of the wafer stage WST1 using the heads 90x facing the scale 290 and the scale 290, and also measuring the position in the Y-axis direction of the wafer stage WST1 using the heads 90y facing the scale 290 and the scale 290, the wafer stage WST1 is moved in the +Y direction.

Then, as shown in FIG. 13A, at the moment in which the length-measuring beam of the interferometer 18B is irradiated to the -X-side reflective surface of the fine movement stage WFS1, the measurement relating to the Y-axis direction is switched to the measurement by the interferometer 18B, and the wafer stage WST1 is moved to the position (wafer exchange position) shown in FIG. 13B.

Then, on the wafer stage WST2 side, a step-and-scan exposure operation is performed on the wafer W2, similar to the exposure operation performed on the wafer W1, and on the wafer stage WST1 side, wafer exchange and wafer alignment operations are executed in a similar manner to those discussed above.

Thus, in the exposure apparatus 10 of this embodiment, while performing exchange of the wafer stages WST1 and WST2, the exposure operation to a wafer on one wafer stage, and the wafer exchange and the wafer alignment operation of a wafer on the other wafer stage are performed by simultaneous parallel processing.

In this embodiment, during the foregoing parallel processing, a state, in which the upper surface of the power-receiving, heat-dissipating arm 20A of the wafer stage WST1 and the lower surface of at least one of power-transmitting, waste-heat frames 24A and 24B are facing each other, is maintained, and therefore the supply of electric power to the wafer stage WST1, the transfer of heat generated at the wafer stage WST1, and signal transmission and reception can be performed in the facing portions.

Also with respect to the wafer stage WST2, similarly to wafer stage WST1, the upper surface of the power-receiving, heat-dissipating arm 20B and the lower surface of at least one of power-transmitting, waste-heat frames 24A and 24B are facing each other, and therefore the supply of electric power to the wafer stage WST2, the transfer of heat generated at the wafer stage WST2, and signal transmission and reception can be performed in the facing portions.

As is discussed above in detail, according to this embodiment, because the power-transmitting, waste-heat frames 24A and 24B continually absorb heat radiated from the heat-dissipating section 86E of the wafer stage WST1 (WST2), adverse influences of heat generated in the wafer stage WST1 (WST2) on exposure accuracy can be suppressed. In this case, since it is unnecessary to connect a conduit (tube) from the outside to the wafer stage WST1 (WST2) for supplying coolant, declines in movement accuracy of the wafer stage WST1 (WST2) due to conduit tension can be prevented, thereby maintaining exposure accuracy at high accuracy.

Further, in this embodiment, the electric-power-input system 84 by which electric power is input wirelessly to the wafer stages WST1 and WST2 are provided, and also the transmitters 184 and 284 for outputting electric power wirelessly to the receiver 84A of the electric-power-input system are disposed on the power-transmitting, waste-heat frames 24A and 24B. Hence, the wiring to supply electric current to the driving mechanisms that drive the respective constituents of the wafer stages WST1 and WST2 does not have to be connected from the outside to the wafer stages WST1 and WST2, which makes it possible to prevent declines in movement accuracy of the wafer stages WST1 and WST2 caused by tension of such wiring. This can also improve exposure accuracy.

Further, in this embodiment, the transmitters 88D for transmitting wirelessly the signals output from the meters on the stages (e.g., field-image meters FM1 and FM2) are provided on the wafer stages WST1 and WST2, and the receivers 188 and 288 for receiving signals from the transmitters 88D are provided on the power-transmitting, waste-heat frames 24A and 24B. Hence, wiring used for taking the signals output from the detectors need not to be connected to the wafer stages WST1 and WST2 from the outside. Accordingly, also in this case, it becomes possible to prevent declines in movement accuracy of the stages due to tension of the wiring as in the conventional case, and hence exposure accuracy can be improved.

Further, according to this embodiment, the two wafer stages WST1 and WST2 are equipped with which high-accuracy alignment is possible as is discussed above, and the two wafer stages move between a position directly below the projection optical system PO (exposure position) and a position directly below the alignment system ALG (alignment position), and therefore the wafer exposure operation and the wafer alignment operation can be performed in parallel. Accordingly, it becomes possible to perform high-accuracy exposure with high throughput.

Further, according to this embodiment, the wafer stage WST1 (WST2) is equipped with the coarse movement stage WRS1 (WRS2) and the fine movement stage WFS1 (WFS2), and the coils for all the voice coil motors that constitute the planar motors, the fine movement mechanism 140, and the empty-weight-canceling mechanisms 22A1-22A3 (22B1-22B3) are disposed on the coarse movement stage WRS1 (WRS2) side, and therefore the wiring to supply electric current for driving to the fine movement stage WFS1 (WFS2) does not have to be connected. Thus, more accurate wafer alignment can be achieved because the wiring is not connected from the coarse movement stage to the fine movement stage requiring high alignment accuracy. Also, because the coolant supply may be performed only on the coarse movement stage side due to the coils being disposed only on the coarse movement stage side, it is unnecessary to arrange a coolant supply conduit between the coarse movement stage and the fine movement stage, which also makes it possible to achieve high-accuracy wafer alignment.

Further, in this embodiment, each of the voice coil motors constituting the fine movement mechanism 140 generates a driving force in a direction intersecting the X-axis and the Y-axis at 45 degrees, and the fine movement stages WFS1 and WFS2 are driven in the X-axis and Y-axis directions by the resultants of these driving forces. Consequently, the electric current consumed by one voice coil motor can be suppressed, compared to the case of simply using a voice coil motor that generates a driving force in the X-axis direction and a voice coil motor that generates a driving force in the Y-axis direction. Accordingly, the heat generation by the motors can be suppressed, and therefore, declines in exposure accuracy caused by the heat generation can be suppressed.

Further, in this embodiment, since the protective plate 26 is disposed on the base BS, when the supply of electric current to the coils constituting the armature unit 130 of the planar motor is stopped, damage to the permanent magnets on the base BS in instances in which the wafer stage falls onto the base BS can be prevented.

Further, in the embodiment above, the heads 90x and 90y and scales 190 and 290 are provided, and measurements of the wafer stages WST1 and WST2 are performed at a point where the length-measuring beam from each interferometer does not strike. Hence, even when the wafer stages WST1 and WST2 move between a position directly below the projection-optical system PO and a position directly below the alignment system ALG as in the embodiment above, the interferometer disposition as in FIG. 2 is sufficient. This allows a reduction in the number of interferometers.

In the embodiment above, a case was described in which heat generated by the wafer stage WST1 (WST2) is radiated into the heat-dissipating section 86E disposed in the liquid-temperature-regulating system 86 to which the coolant conduit line 202 for circulating coolant into the wafer stage WST1 (WST2)) is connected. But, this configuration is not intended to be limiting, and the power-transmitting, waste-heat frames 24A and 24B may also absorb the heat radiated directly from the wafer stage WST1 (WST2), without providing the coolant conduit line 202, heat dissipating section 86E, and the like.

In the embodiment above, plate-shaped members that are narrow in the X-axis direction are used as the power-transmitting, waste-heat frames 24A and 24B. However, this configuration is not intended to be limiting, and the size (width in the X-axis direction) of these members can be increased so long as exposure and alignment are not affected. In this case, it is also possible to make the area of the heat-dissipating section 86E smaller (to make it local), and to make the power-transmitting, waste-heat frame have approximately the same area as the upper surface of the base BS. Further, the power-transmitting, waste-heat frame is not limited to being disposed on the ceiling side (above the wafer stage WST), but alternatively, this frame can be disposed on the floor side (below the wafer stage WST), and the heat-dissipating section 86E may also be disposed on the lower surface side of the wafer stage WST. Further, a lattice-shaped power-transmitting, waste-heat frame, configured by unifying the two power-transmitting, waste-heat frames 24A and 24B in the embodiment above, may be employed.

Further, in the embodiment above, a case was described in which coolant is supplied to the waste-heat sections 186 and 286 of the power-transmitting, waste-heat frames 24A and 24B to cool down waste-heat sections 186 and 286. However, this configuration is not intended to be limiting, and for example, a cooling mechanism such as a Peltier element or the like may be provided on the waste-heat section. Also, if attention is focused only on the fact that the waste-heat sections 186 and 286 of the power-transmitting, waste-heat frames 24A and 24B absorb heat radiated from the heat-dissipating section, coolant needs not be supplied.

In the embodiment above, a case was described in which either of the power-transmitting, waste-heat frames 24A and 24B is continually in opposition to (facing) the waste-heat section 186 and 286. However, this configuration is not intended to be limiting, and sometimes the power-transmitting, waste-heat frames 24A and 24B may deviate somewhat from such an opposition state, if the heat radiated from the waste-heat sections 186 and 286 is absorbed by the power-transmitting, waste-heat frames 24A and 24B. Specifically, in the embodiment above, a case was described in which the power-transmitting, waste-heat frames 24A and 24B are disposed over the entire range of movement in the Y-axis direction of the wafer stage WST. But, this is not intended to be limiting. And, the power-transmitting, waste-heat frames 24A and 24B may alternatively be disposed over a range smaller than the range of movement of the wafer stage WST in the Y-axis direction. In this latter case, without being limited to continuous absorption of radiated heat, there may be situations in which heat is not being absorbed for short periods of time, for example. Specifically, the power-transmitting, waste-heat frame 24A (24B) and the waste-heat section 186 (286) can be opposed to each other at least in a range in which the wafer stage WST1 (WST2) moves during exposure of a wafer on the wafer stage WST1 (WST2), for example.

In the embodiment above, a case was described in which the power-transmitting, waste-heat frames 24A and 24B extend in the Y-axis direction and the power-receiving, heat-dissipating arms 20A and 20B extend in the X-axis direction. However, this configuration is not intended to be limiting, and the power-transmitting, waste-heat frames 24A and 24B may alternatively extend in the X-axis direction while the power-receiving, heat-dissipating arms 20A and 20B extend in the Y-axis direction. Also, without being limited to the X- and Y-axis directions, one of the power-transmitting, waste-heat frames 24A and 24B, and power-receiving, heat-dissipating arms 20A and 20B may extend in a predetermined direction in the X-Y plane, and the other may extend in a direction intersecting the predetermined direction in the X-Y plane.

In the embodiment above, a case was described in which the armature unit of the planar motor is disposed on the wafer stage side. However, this configuration is not intended to be limiting, and the armature unit alternatively may be disposed on the base BS side and the magnet unit may be disposed on the wafer stage side. Further, in the embodiment above, a case was described in which the coil side of all the voice coil motors of the fine movement mechanism 140 and empty-weight-canceling mechanisms 22A1-22A3 (22B1-22B3) is situated on the coarse movement stage WRS1 (WRS2) side. However, this configuration is not intended to be limiting, and the coils alternatively may be situated on the fine movement stage side, in the case when there is no adverse influence of such a configuration on the movement of the fine movement stage, even when wiring is arranged between the coarse movement stage and fine movement stage.

In the embodiment above, a case was described in which the following are performed between the power-transmitting, waste-heat frames 24A and 24B, and the power-receiving, heat-dissipating arms 20A and 20B: wireless transmission of electric power, transfer of heat, transmission and reception of detection signals from the detectors, and position measurement when a length-measuring beam is not irradiated from the interferometer. However, this configuration is not intended to be limiting, and at least only one of the above may be performed.

In the embodiment above, a case was described in which a thick plate as shown in FIG. 5 is used as a magnetic-flux-leakage preventing plate 36. However, this configuration is not intended to be limiting, and a thin, plate-shaped plate may alternatively be employed and may be placed above the base BS via a spacer member, so that the height of the upper surface thereof is the same as the height of the upper surface of the magnetic-flux-leakage preventing plate 36 shown in FIG. 5.

In the embodiment above, the interferometer system and encoder (head section 90, and scales 190 and 290) are used in combination to perform position measurements of the wafer stages WST1 and WST2. However, this configuration is not intended to be limiting, and by increasing the number of interferometers constituting the interferometer system, position measurements of the wafer stages WST1 and WST2 may be performed using only the interferometer system; or alternatively, the position measurements of the wafer stages WST1 and WST2 can be performed using only the encoder.

In the embodiment above, a case was described in which, in the movable element 50 constituting the fine movement apparatus 140, the direction in which the magnet units 52A and 52C are aligned and the direction in which the magnet units 52B and 52D are aligned are inclined at 45 degrees relative to the X-axis and Y-axis. However, this configuration is not intended to be limiting, and as long as the direction in which the magnet units 52A and 52C are aligned and the direction in which the magnet units 52B and 52D are aligned are directions that intersect the X-axis and Y-axis in the X-Y plane, the angle with respect to the X-axis and Y-axis may be any angle. Further, in the embodiment above, a case was described in which each of the voice coil motors of the fine movement apparatus 140 generates a driving force in a direction inclined at 45 degrees with respect to the X-axis and Y-axis in the X-Y plane. However, this configuration is not intended to be limiting, and the angle is immaterial so long as each driving force is generated in a direction that intersects the X-axis and Y-axis in the X-Y plane.

In the embodiment above, a case was described in which the protective plate 26 composed of a nonmagnetic body is disposed on the upper surface of the base BS in a state of covering the magnet unit 30 from above. However, this configuration is not intended to be limiting, and alternatively, a protective plate may be disposed on the lower surface of the wafer stages WST1 and WST2. With this alternative protective plate, direct contact between the wafer stages WST1 and WST2, and the permanent magnets 28N, 28S and 32 is prevented in the similar manner to the case of the protective plate 26 in the embodiment above, and thus, damage to the permanent magnets 28N, 28S and 32 can be prevented.

In the embodiment above, a case was described in which the present invention is applied to a wafer stage apparatus having two wafer stages. However, the present invention is not limited to this configuration, and the present invention can also be applied to a wafer stage apparatus having only one wafer stage, or can also be applied to a wafer stage apparatus having three or more wafer stages.

Further, in the embodiment above, a case was described in which only one alignment system ALG is provided. However, this configuration is not intended to be limiting, and alternatively, a configuration can also be employed in which two alignment systems ALG are provided, corresponding to the wafer stages WST1 and WST2.

Alternatively to using a wafer focus sensor as in the embodiment above, a surface-form-detection device may be provided in a body holding the projection optical system PO. Such a surface-form-detection device is configured including: an irradiation system for making a line-shaped beam, which is, for example, longer than a diameter of a wafer, obliquely incident on the wafer; and a light-receiving system having a detector for receiving the reflected light of the beam irradiated by the irradiation system, such as a one-dimensional CCD sensor, line sensor, or the like. Thus, using a plurality of point-shaped irradiation regions as measurement points, the Z-position (positional information relating to the Z-axis direction, perpendicular to a predetermined plane (X-Y plane) in which the wafer moves) of a wafer can be detected at each measurement point, in the same principle as the known detection principle of multipoint AF system. In this case, before starting exposure, when a wafer passes through the irradiation region of the surface-form-detection device, the distribution of the Z-position information of the wafer surface is calculated based on the measurement values (the position of the wafer) from the interferometer system or head section 90 and the detection results from the detection apparatus, and during the exposure operation, the position and attitude of the wafer stage relative to the Z-axis direction can be controlled based on the calculation results.

In the embodiment above, a planar motor is used as a driving device for driving the wafer stages WST1 and WST2 with a long stroke. But, this is not intended to be limiting, and a linear motor alternatively may be used.

The wafer stages WST1 and WST2 in the embodiment above are not connected to wiring and conduits, but alternatively, wiring-conduit ports can be provided on a portion of the wafer stages WST1 and WST2 so that direct electric power supply or the like can be performed to the wafer stages WST1 and WST2 in the event of an emergency such as malfunction or the like.

In the embodiment above, a case was described in which the fine movement mechanism 140 and empty-weight-canceling mechanisms 22A1-22A3 and 22B1-22B3 are provided on the wafer stages WST1 and WST2. However, this is not intended to be limiting, and either mechanism may be provided, or a conventional voice coil motor may be provided instead of the fine movement mechanism and empty-weight-canceling mechanisms. As the voice coil motor in this case, either a moving-magnet-type voice coil motor or a moving-coil-type voice coil motor can be employed, but a moving-magnet type voice coil motor can be employed from the standpoint of avoiding drag of the wiring, as discussed above.

In the embodiment above, a case was described in which the movable body apparatus of the present invention is employed as a wafer stage apparatus. However, this is not intended to be limiting, and it alternatively is possible to employ the movable body apparatus on the reticle stage RST side.

In addition, in the embodiment above, a case was described in which the present invention is employed in a wafer stage for holding a wafer surface parallel to the horizontal plane (X-Y plane). However, this is not intended to be limiting, and the present invention can also be employed in a wafer stage (vertical wafer stage) for holding a wafer surface substantially parallel to a plane orthogonal to the X-Y plane.

The present invention can also be applied to a liquid immersion exposure apparatus disclosed in the pamphlet of International Publication No. WO 2004/053955. Also, the exposure apparatus of the embodiment above may be equipped with a measurement stage that is separate from the wafer stage(s), as disclosed in, for example, the pamphlet of International Publication No. WO 2005/074014, and the like. In this case, the movable body apparatus of the present invention can be employed as a measurement stage MST, along with the wafer stage WST or instead of the wafer stage WST.

Further, in the embodiment above, a case was described in which the present invention is applied to a scanning-type exposure apparatus by the step-and-scan method, or the like. However, it goes without saying that the application range of the present invention is not limited thereto. Specifically, the present invention can also be applied to a projection exposure apparatus by a step-and-repeat method, further to an exposure apparatus by a step-and-stitch method, or to an exposure apparatus by a proximity method, a mirror projection aligner, or the like.

The use of the exposure apparatus is not limited to exposure apparatus for semiconductor manufacturing, but for example, the apparatus can be widely applied to exposure apparatus used for liquid crystal that transfer a liquid crystal display element pattern to a rectangular glass plate, to exposure apparatus for manufacturing organic ELs, thin-film magnetic heads, imaging elements (CCDs and the like), micromachines, DNA chips, and the like. Further, the present invention is also applicable to exposure apparatus that transfer circuit patterns to glass substrates, silicon wafers or the like, not only for manufacturing microdevices such as semiconductor elements, but also for manufacturing reticles or masks used in optical exposure apparatus, EUV exposure apparatus, X-ray exposure apparatus, electron-beam exposure apparatus, and the like.

In the embodiment above, a case was described in which EUV light having a wavelength of 11 nm is used as the exposure light. However, this wavelength is not intended to be limiting, and alternatively, EUV light having a wavelength of 13 nm may also be used. In this case, to ensure an approximately 70% reflectance to the 13-nm wavelength EUV light, it is necessary to use a multilayer film composed of alternating layers of molybdenum (Mo) and silicon (Si), as the reflective film on each mirror.

Further, in the embodiment above, SOR (Synchrotron Orbital Radiation) is used as the source of exposure light. However, this is not intended to be limiting, and alternatively, either of laser-excited plasma light source, betatron light source, discharge light source, X-ray laser, or the like may be used.

In the exposure apparatus of the embodiment above, light having a wavelength of 100 nm or less is used as the exposure light. However, this is not intended to be limiting, and alternatively, light having a wavelength of 100 nm or greater can also be used (such as pulsed laser beams such as an ArF excimer laser beam (wavelength: 193 nm), a KrF excimer laser beam (wavelength: 248 nm), an F₂ laser beam (wavelength: 157 nm), an Ar₂ laser beam (wavelength: 126 nm), and a Kr₂ laser beam (wavelength: 146 nm); and emission lines such as g-line (wavelength: 436 nm), and i-line (wavelength: 365 nm) from an extra-high-pressure mercury lamp). Further, the projection optical system is not limited to a demagnifying system, but alternatively, can be either a magnifying or enlarging system. Furthermore, the projection optical system is not limited to being a reflection type projection optical system composed of only reflecting optical elements, but alternatively, it is also possible to use a reflecting-refracting type projection optical system (catadioptric system) having reflective optical element(s) and refractive optical element(s), or a refractive type projection optical system having only refractive optical element (s) .

The present invention can also be applied to an exposure apparatus using a charged particle beam such as an electron beam, an ion beam, or the like.

Further, in the embodiment above, a light-transmissive type mask (reticle), which is a light-transmitting substrate on which a predetermined light-shielding pattern (or a phase pattern or a light-attenuation pattern) is formed, is used. As an alternative to this reticle, an electronic mask (or variable-shaped mask, for example, a DMD (Digital Micro-mirror Device) which is a type of non-light-emitting image display element (also called a "spatial light modulator")) on which a transmitting pattern, a reflective pattern, or a light-emitting pattern is formed based on the electronic data of the pattern to be exposed, may also be sued, as disclosed in, for example, U.S. Patent No. 6,778,257. When using such a variable-shaped mask, the relative positional control of the wafer and pattern image may be performed by varying the transmitting pattern or reflective pattern to be formed based on electronic data, with consideration of the detection results of the alignment mark discussed above, during the exposure of at least one separate shot region for which exposure is performed after a shot region which was exposed at the time of the alignment mark detection, from among the plurality of divided regions on the wafer.

Further, as is disclosed in the pamphlet of International Publication No. WO 2001/035168, the present invention can also be applied to an exposure apparatus (lithography system) that forms line-and-space patterns on a wafer by forming interference fringes on the wafer.

Moreover, the present invention can also be applied to an exposure apparatus that synthesizes two reticle patterns on a wafer via a projection optical system and almost simultaneously performs double exposure of one shot region on the wafer by one scanning exposure, as is disclosed in, for example, Kohyo (published Japanese translation of International Publication for Patent Application) No. 2004-519850 (corresponding to U.S. Patent No. 6,611,316).

As long as the national laws in designated states ( or elected states), to which this international application is applied, permit, the above disclosures of the various publications, the pamphlets of International Publications, and the U.S. Patent descriptions are incorporated herein by reference.

Further, an apparatus that forms a pattern on an object is not limited to the exposure apparatus (the lithography system) described above, but for example, the present invention can also be applied to an apparatus that forms a pattern on an object based on an ink-jet method.

Incidentally, an object on which a pattern should be formed (an object subject to exposure to which an energy beam is irradiated) in the embodiment above is not limited to a wafer, but may be other obj ects such as a glass plate, a ceramic substrate, a mask blank, or the like.

Further, the exposure apparatus of the embodiment above is manufactured by assembling various subsystems, which include the respective constituents that are recited in the claims of the present application, so as to keep predetermined mechanical accuracy, electrical accuracy and optical accuracy. In order to secure these various kinds of accuracy, before and after the assembly, adjustment to achieve the optical accuracy for various optical systems, adjustment to achieve the mechanical accuracy for various mechanical systems, and adjustment to achieve the electrical accuracy for various electric systems are performed. A process of assembling various subsystems into the exposure apparatus includes mechanical connection, wiring connection of electric circuits, piping connection of pressure circuits, and the like among various types of subsystems. Needless to say, an assembly process of individual subsystem is performed before the process of assembling the various subsystems into the exposure apparatus. When the process of assembling the various subsystems into the exposure apparatus is completed, a total adjustment is performed and various kinds of accuracy as the entire exposure apparatus are secured. Incidentally, the making of the exposure apparatus is preferably performed in a clean room where the temperature, the degree of cleanliness and the like are controlled.

Semiconductor devices are manufactured through the following steps: a step where the function/performance design of the device is performed; a step where a reticle is manufactured based on the design step; a step where a wafer is manufactured using silicon materials; a lithography step where the pattern formed on the mask is transferred onto the wafer by the exposure apparatus of the embodiment above; a device assembly step (including a dicing process, a bonding process, and a packaging process); an inspection step; and the like. In this case, since the exposure apparatus of the embodiment above is used in the lithography step, productivity of devices with high degrees of integration can be improved.

As is described above, the movable body apparatus and the fine movement member of the present invention are suitable for being used in an exposure apparatus. Further, the exposure apparatus and the exposure method of the present invention are suitable for forming a pattern on an object by exposing the object. Further, the device manufacturing method of the present invention is suitable for manufacturing microdevices.

## Claims

1. A movable body apparatus, comprising:
a movable body having a heat-dissipating section;
a driving device that two-dimensionally drives the movable body in a predetermined plane; and
a waste-heat member that is disposed in a non-contacting manner relative to the movable body and absorbs heat radiated from the movable body; wherein
one of the waste-heat member and the heat-dissipating section extends over a predetermined range in one axial direction in the predetermined plane, and the other of the waste-heat member and the heat-dissipating section extends over a predetermined range in a direction orthogonal to the one axial direction in the predetermined plane.

2. The movable body apparatus of Claim 1, wherein
the heat-dissipating section extends in one of the one axial direction and the direction orthogonal thereto , and
the waste-heat member extends in the other of the one axial direction and the direction orthogonal thereto, and is disposed at a plurality of positions spaced apart in the one of the directions.

3. The movable body apparatus of Claim 2, wherein
the heat-dissipating section is disposed on one surface of the movable body substantially parallel to the predetermined plane.

4. The movable body apparatus of Claim 3, wherein
the movable body has a heat-dissipating mechanism that includes the heat-dissipating section and discharges heat produced by cooling the movable body.

5. The movable body apparatus of Claim 4, wherein
the heat-dissipating mechanism has a circulation system that circulates a coolant and a temperature-regulating section that regulates temperature of the coolant, and
the waste-heat member is disposed in a state of continually opposed to at least part of the temperature-regulating section, and absorbs heat radiated from the temperature-regulating section.

6. The movable body apparatus of Claim 5, wherein
the circulation system has a conduit that carries a coolant and a pump, and
the temperature-regulating section has a cooling mechanism that absorbs heat from the coolant and dissipates the heat to the outside.

7. The movable body apparatus of Claim 1, wherein
the waste-heat member has an electric-power-output section that wirelessly outputs electric power, and
the movable body has an electric-power-input section that inputs electric power output wirelessly from the electric-power-output section.

8. The movable body apparatus of Claim 7, wherein
the movable body has a heat-dissipating mechanism that includes the heat-dissipating section and dissipates heat absorbed by the waste-heat member, and
the heat-dissipating mechanism uses the input electric power.

9. The movable body apparatus of Claim 7, wherein
the input electric power is used to cool the movable body.

10. The movable body apparatus of Claim 7, wherein
the driving device drives the movable body by using electric power input to the electric-power-input section.

11. The movable body apparatus of Claim 1, wherein
the movable body has a transmitter that wirelessly transmits a signal output from a meter disposed on the movable body, and
the waste-heat member has a receiver that receives a signal transmitted wirelessly from the transmitter.

12. The movable body apparatus of Claim 11, wherein
the movable body has
a coarse movement stage that moves at least in one axial direction in the predetermined plane, and
a fine movement stage that finely moves relative to the coarse movement stage.

13. The movable body apparatus of Claim 12, wherein
the driving device includes a moving-magnet-type fine movement mechanism that has a movable element including a plurality of magnets disposed on the fine movement stage, and a fixed element including a plurality of coils disposed on the coarse movement stage, and
the fine movement stage is finely driven relative to the coarse movement stage by the fine movement mechanism.

14. The movable body apparatus of Claim 13, wherein
the fine movement mechanism includes a first fine movement unit that generates a driving force in a first direction intersecting a first axis direction and a second axis direction that are orthogonal in the predetermined plane, and a second fine movement unit that generates a driving force in a second direction that intersects the first axis direction, the second axis direction, and the first direction in the predetermined plane, and
the fine movement stage is driven in at least one of the first axis direction, the second axis direction, and a rotary direction in the predetermined plane, by a resultant of the driving forces generated by the first and second fine movement units.

15. The movable body apparatus of Claim 13, wherein
the movable body is driven in a horizontal plane orthogonal to a gravitational force direction, and
the driving device includes an empty-weight-canceling mechanism that cancels an empty weight of the fine movement stage, and a moving-magnet-type voice coil motor that makes a driving force in the gravitational force direction act on the fine movement stage.

16. The movable body apparatus of Claim 15, wherein
the movable body has a heat-dissipating mechanism at least part of which is disposed on the coarse movement stage, the part including a heat-dissipating section that is opposed to the waste-heat member.

17. The movable body apparatus of Claim 1, further comprising:
a base whose movement surface on which the movable body is placed is set substantially horizontal, wherein
the driving device has
a magnet unit disposed on the base and having a plurality of permanent magnets arrayed in two-dimensional directions, and
an armature unit disposed on the movable body and having a plurality of armature coils situated in two-dimensional directions in a state of opposed to the magnet unit, wherein
the movable body is driven by electromagnetic interaction between the magnet unit and the armature unit.

18. The movable body apparatus of Claim 17, wherein
the magnet unit includes a plurality of thrust-generating magnets that are arrayed so that polarities of adjacent magnet faces are different from each other and have rectangular magnet faces, and a plurality of interpolation magnets that are arranged in a path of magnetic flux formed between adjacent thrust-generating magnets and intensify a magnetomotive force.

19. The movable body apparatus of Claim 18, wherein
the driving device generates a levitational force, in a gravitational-force direction, on the movable body by electromagnetic interaction between the magnet unit and the armature unit.

20. The movable body apparatus of Claim 19, further comprising:
a magnetic body member that is disposed on the movable body, and generates a magnetic attraction with the magnet unit and maintains a predetermined gap between the movable body and the base by a balance between the magnetic attraction and the levitational force.

21. The movable body apparatus of Claim 20, further comprising:
a nonmagnetic-body protective member that prevents contact between the magnet unit and the movable body.

22. The movable body apparatus of Claim 21, further comprising:
a cover member that can be installed on the movement surface of the base, and suppresses or prevents leakage of magnetic flux from the magnet unit when the movable body is not in use.

23. The movable body apparatus of Claim 1, further comprising:
an encoder that has a scale that is disposed on one of the waste-heat member and the movable body, and a head that is disposed on the other of the waste-heat member and the movable body and irradiates a light beam to the scale.

24. The movable body apparatus of Claim 23, further comprising:
an interferometer that detects positional information of the movable body, wherein
detection of the positional information of the movable body using the encoder is executed at least when detection of the positional information of the movable body using the interferometer cannot be performed.

25. The movable body apparatus of Claim 1, further comprising:
a temperature-regulating apparatus that regulates temperature of the waste-heat member.

26. The movable body apparatus of Claim 25, wherein
a plurality of the movable bodies are provided, and the waste-heat member absorbs heat radiated from each of the movable bodies.

27. The movable body apparatus of Claim 26, wherein
the plurality of the movable bodies can mutually exchange their positions in a predetermined direction.

28. The movable body apparatus of Claim 27, wherein
the waste-heat member has a longitudinal direction in the predetermined direction, and is disposed at a plurality of positions at an interval approximately less than or equal to a width of the movable body in a direction orthogonal to the predetermined direction in the predetermined plane.

29. The movable body apparatus of Claim 28, further comprising:
a measurement apparatus that measures positional information of the movable body that is driven by the driving device in a first region of the predetermined plane, wherein
during the driving by the driving device at least in the first region, position control of the moving body is performed using the positional information measured by the measurement apparatus, and also the radiated heat is absorbed by the waste-heat member.

30. The movable body apparatus of Claim 29, wherein
the driving device drives the movable body situated in a second region that is different at least in part from the first region, and
the waste-heat member absorbs heat radiated from the movable body during the driving in the second region.

31. The movable body apparatus of Claim 30, wherein
in exchange of a first movable body situated in the first region from among the plurality of the movable bodies, a second movable body situated in the second region is placed in the first region.

32. The movable body apparatus of Claim 31, wherein
different operations are executed to objects mounted on the respective movable bodies in the first and second regions, and
the driving device drives the respective movable bodies in the first and second regions so that at least respective parts of the different operations are performed in parallel.

33. The movable body apparatus of Claim 32, wherein
each of the plurality of the movable bodies is driven two-dimensionally, and has a heat-dissipating mechanism in which a heat-dissipating section extends in the first axis direction in the predetermined plane, and
the waste-heat member is disposed intersecting the first axis direction in the predetermined plane.

34. The movable body apparatus of Claim 33, wherein
the waste-heat member extends in the second axis direction orthogonal to the first axis direction in the predetermined plane, and is disposed at a plurality of positions spaced apart in the first axis direction, and
the heat-dissipating section extends over a predetermined range no less than an interval between a plurality of the waste-heat members in the first axis direction.

35. The movable body apparatus of Claim 33, wherein
the waste-heat members extends in the second axis direction orthogonal to the first axis direction in the predetermined plane, and is disposed at a plurality of positions at an interval approximately less than or equal to a width of the heat-dissipating section in the first axis direction.

36. A movable body apparatus, comprising:
a movable body;
an electric-power-input section which is disposed on the movable body and to which electric power is wirelessly input;
an electric-power-output section that is disposed in a non-contacting manner relative to the movable body in a state of continually opposed to at least part of the electric-power-input section, and wirelessly outputs electric power toward the electric-power-input section; and
a driving device that drives the movable body by using electric power input to the electric-power-input section.

37. The movable body apparatus of Claim 36, further comprising
a waste-heat member that is disposed in a non-contacting manner relative to the movable body in a state of continually opposed to at least part of the movable body, and absorbs heat radiated from the movable body.

38. A movable body apparatus, comprising:
a movable body;
a meter disposed on the movable body;
a transmitter that is disposed on the movable body and wirelessly transmits a signal output from the meter; and
a receiver that is disposed in a non-contacting manner relative to the movable body in a state of continually opposed to at least part of the transmitter, and receives a signal transmitted wirelessly from the transmitter.

39. The movable body apparatus of Claim 1, wherein
the movable body is situated in a vacuum or subatmospheric pressure environment.

40. An exposure apparatus that forms a pattern on an object by exposing the object, the apparatus comprising:
the movable body apparatus according to Claim 1, in which the object is mounted on the movable body.

41. An exposure apparatus that forms a pattern on an object by exposing the object, the apparatus comprising:
the movable body apparatus according to Claim 26, wherein
in exchange of one movable body of the plurality of movable bodies on which the object is mounted, another movable body, on which an object to be exposed next to the object on the one movable body is mounted, is placed at an exposure position where exposure of the object is performed in the predetermined plane.

42. The exposure apparatus of Claim 41, wherein
in parallel with at least part of an exposure operation of the obj ect on the one movable body, measurement of the obj ect mounted on the another movable body is performed at a measurement position that is different from the exposure position in the predetermined plane, and
the another movable body is moved from the measurement position to the exposure position.

43. The exposure apparatus of Claim 42, further comprising:
a measurement apparatus that measures, in an independent manner, positional information of the movable body in a first region including the exposure position in the predetermined plane, and positional information of the movable body in a second region, of which at least part is different from the first region, and which includes the measurement position in the predetermined plane.

44. The exposure apparatus of Claim 43, wherein
the waste-heat member absorbs at least heat radiated from the movable body situated at the exposure position.

45. The exposure apparatus of Claim 44, wherein
the waste-heat member is disposed on a side of a mounting surface of the movable body,
the movable body has a heat-dissipating mechanism in which the heat-dissipating section is situated on the side of the mounting surface, and
heat is absorbed by the waste-heat member via the heat-dissipating section.

46. The exposure apparatus of Claim 45, wherein
the movable body is situated in a vacuum or subatmospheric pressure environment.

47. An exposure method of forming a pattern on an object, the method comprising:
driving the movable body of the movable body apparatus according to Claim 1 in a state where the object is mounted on the movable body, when exposure of the object is performed.

48. An exposure method of forming a pattern on an object, the method comprising:
by using the movable body apparatus according to Claim 26, driving one movable body of the plurality of the movable bodies that is situated at an exposure position where exposure of the object is performed in the predetermined plane, and placing another movable body, on which an object to be exposed next to the object on the one movable body is mounted, at the exposure position in exchange of the one movable body.

49. A device manufacturing method comprising a lithography process, wherein
in the lithography process, a pattern is formed on a substrate, using the exposure method according to Claim 47.

50. A device manufacturing method comprising a lithography process, wherein
in the lithography process, a pattern is formed on a substrate using the exposure apparatus according to Claim 40.

51. A movable body apparatus, comprising:
a movable body;
a fine movement member supported in a non-contacting manner relative to the movable body; and
a driving mechanism having four armature coils that are disposed on the movable body and a magnet unit that is disposed on the fine movement member and cooperatively operates with the four armature coils to generate a driving force.

52. The movable body apparatus of Claim 51, wherein
the magnet unit includes at least one pair of magnets opposed to each other via any of the four armature coils, and
opposed portions of the magnets forming the pair are of opposite polarity.

53. The movable body apparatus of Claim 51, wherein
the driving mechanism makes at least one of a translational driving force in a two-dimensional plane and a rotary driving force in the two-dimensional plane act on the fine movement member by selectively supplying electric current to the four coils.

54. The movable body apparatus of Claim 51, further comprising:
an empty-weight-canceling mechanism that is disposed on the movable body and supports an empty weight of the fine movement member.

55. The movable body apparatus of Claim 54, wherein
the fine movement member and the empty-weight-canceling mechanism do not contact with each other.

56. The movable body apparatus of Claim 54, wherein
the empty-weight-canceling mechanism makes a moving force in a direction perpendicular to the two-dimensional plane and a moving force in a direction inclined with respect to the two-dimensional plane, act on the fine movement member.

57. The movable body apparatus of Claim 51, wherein
the fine movement member is situated above the movable body in a vertical direction.

58. The movable body apparatus of Claim 51, further comprising:
a planar motor that drives the movable body.

59. A fine movement member that is supported finely drivable relative to a movable body, the member comprising:
a fine movement main body supported in a non-contacting manner relative to the movable body; and
a magnet unit that is disposed on the fine movement main body, and operates cooperatively with four armature coils disposed on the movable body to generate a driving force.

60. The fine movement member of Claim 59, wherein
the magnet unit includes at least one pair of magnets opposed to each other via any of the four armature coils, and
opposed portions of the magnets forming the pair are of opposite polarity.

61. The fine movement member of Claim 59, wherein
the empty weight of the fine movement main body and the magnet unit are supported by an empty-weight-canceling mechanism disposed on the movable body.

62. The fine movement member of Claim 61, wherein
the fine movement main body and the empty-weight-canceling mechanism do not contact with each other.

63. The fine movement member of Claim 62, wherein
the empty-weight-canceling mechanism makes a moving force in a direction perpendicular to a two-dimensional plane and a moving force in a direction inclined with respect to the two-dimensional plane, act on the fine movement main body.

64. A movable body apparatus, comprising:
a movable body; and
the fine movement member according to Claim 59 supported in a non-contacting manner relative to the movable body.

65. An exposure apparatus that forms a pattern on an object, the apparatus comprising:
the movable body apparatus according to Claim 51, in which the object is mounted on the fine movement member.
